# EUROPEAN PATENT APPLICATION

(11) **EP 4 529 384 A1**
(43) Date of publication of application: **26.03.2025**
(21) Application number: 24185969.3
(22) Date of filing: 02.07.2024
(51) Int. Cl.: H10B 43/10, H10B 43/50

(54) **SEMICONDUCTOR DEVICES AND DATA STORAGE SYSTEMS INCLUDING THE SAME**

(30) Priority: 21.09.2023 KR 20230126471
(71) Applicant: Samsung Electronics Co., Ltd., Suwon-si, Gyeonggi-do 16677 (KR)
(72) Inventor: LEE, Wooyoung, 16677 Suwon-si (KR); LEE, Junghwan, 16677 Suwon-si (KR)
(74) Representative: Marks & Clerk LLP

(57) **Abstract**

A semiconductor device includes: a stack structure including gate electrodes (130) that are spaced apart from each other in a first direction (Z), perpendicular to an upper surface of a substrate, in a first region (R1) and a second region (R2); separation regions (MS1, MS2a) extending through the stack structure and extending in a second direction (X), perpendicular to the first direction (Z), in the first region (R1) and the second region (R2); a plurality of channel structures (CH) extending through the stack structure, in a cell region (R1a) of the first region (R1); a plurality of dummy channel structures (DCH) extending through the stack structure, in a buffer region (RB1) of the first region (R1); and a plurality of support structures (SH) extending through the stack structure, in the second region (R2). The first region (R1) and the second region (R2) are sequentially arranged in the second direction (X). The separation regions (MS1, MS2a) include a first separation region (MS1) and a second separation region (MS2a), adjacent to each other in a third direction (Y), and perpendicular to the first direction (Z) and the second direction (X). Between the first and second separation regions (MS1, MS2a), the dummy channel structures (DCH) include a first dummy group (DG1) adjacent to the cell region (R!a) and including first dummy channel structures sequentially arranged in the third direction (Y), and a second dummy group (DGn) adjacent to the second region (R2) and including second dummy channel structures sequentially arranged in the third direction (Y). A first length (da) of the first dummy group (DG1) in the third direction (Y) is longer than a second length (Db) of the second dummy group (DGn) in the third direction (Y).

## Description

### BACKGROUND

The present disclosure relates to semiconductor devices and data storage systems including the same.

There is a general need for a semiconductor device capable of storing high-capacitance data in a data storage system requiring data storage. Accordingly, a method for increasing data storage capacitance of a semiconductor device is being studied. For example, a semiconductor device including three-dimensionally arranged memory cells instead of two-dimensionally arranged memory cells has been proposed as one of the methods for increasing a data storage capacitance of a semiconductor device.

### SUMMARY

An aspect of the present disclosure is to provide a semiconductor device having an improved manufacturing process and which has improved electrical characteristics and reliability.

According to an aspect of the present disclosure, a semiconductor device includes: a stack structure including gate electrodes that are spaced apart from each other in a first direction, perpendicular to an upper surface of a substrate, in a first region and a second region; separation regions extending through the stack structure and extending in a second direction, perpendicular to the first direction, in the first region and the second region; a plurality of channel structures extending through the stack structure, in a cell region of the first region; a plurality of dummy channel structures extending through the stack structure, in a buffer region of the first region; and a plurality of support structures extending through the stack structure, in the second region. The first region and the second region are sequentially arranged in the second direction, the separation regions include a first separation region and a second separation region, adjacent to each other in a third direction, and perpendicular to the first direction and the second direction. Between the first and second separation regions, the dummy channel structures include a first dummy group adjacent to the cell region and including first dummy channel structures sequentially arranged in the third direction, and a second dummy group adjacent to the second region and including second dummy channel structures sequentially arranged in the third direction. A first length of the first dummy group in the third direction is longer than a second length of the second dummy group in the third direction.

According to another aspect of the present disclosure, a semiconductor device includes: a stack structure in a first region and a second region and including gate electrodes and interlayer insulating layers alternately stacked; a plurality of separation regions extending through the stack structure in a third direction; a plurality of channel structures extending through the stack structure, in a cell region of the first region; a plurality of dummy vertical structures extending through the stack structure, in a buffer region of the first region; a plurality of first support structures extending through the stack structure, in a boundary region of the second region; contact plugs connected to contact regions of the gate electrodes, in a connection region of the second region; and a plurality of second support structures extending through the stack structure, in the connection region of the second region. The cell region of the first region, the buffer region of the first region, the boundary region of the second region, and the connection region of the second region are sequentially disposed in a second direction. The separation regions include a first separation region and a second separation region, adjacent to each other in the third direction, perpendicular to a first direction and the second direction. Between a first central axis of the first separation region extending in the second direction and a second central axis of the second separation region extending in the second direction, distances between first dummy vertical structures adjacent to the first separation region among the dummy vertical structures and the first central axis increase from a region adjacent to the cell region of the first region to a region adjacent to the boundary region of the second region.

According to an aspect of the present disclosure, a data storage system includes: a semiconductor storage device including a first semiconductor structure including circuit elements, a second semiconductor structure on one surface of the first semiconductor structure, and an input/output pad electrically connected to the circuit elements; a controller electrically connected to the semiconductor storage device through the input/output pad and configured to control the semiconductor storage device. The second semiconductor structure includes: a stack structure in a first region and a second region and including gate electrodes and interlayer insulating layers alternately stacked; a plurality of separation regions extending through the stack structure in a third direction; a plurality of channel structures extending through the stack structure, in a cell region of the first region; a plurality of dummy vertical structures extending through the stack structure, in a buffer region of the first region; a plurality of first support structures extending through the stack structure, in a boundary region of the second region; contact plugs connected to contact regions of the gate electrodes, in a connection region of the second region; and a plurality of second support structures extending through the stack structure, in the connection region of the second region. The cell region of the first region, the buffer region of the first region, the boundary region of the second region, and the connection region of the second region are sequentially arranged in a second direction. The separation regions include a first separation region and a second separation region, adjacent to each other in the third direction, perpendicular to a first direction and the second direction. Between a first central axis of the first separation region extending in the second direction and a second central axis of the second separation region extending in the second direction, distances between the first dummy vertical structures adjacent to the first separation region among the dummy vertical structures and the first central axis increase from a region adjacent to the cell region of the first region to a region adjacent to the boundary region of the second region.

According to the present disclosure, when forming an opening with an etching process for a separation region, some embodiments may prevent or reduce defects from occurring due to over-etching caused when etching is biased toward a dummy channel structure due to the asymmetry of the Coulomb force between the dummy channel structure and a support structure. That is, the dummy channel structure close to a boundary region between the dummy channel structure and the support structure may be disposed relatively far from the separation region, thereby reducing or minimizing the over-etching. The deformation of the separation region due to the over-etching may be reduced or minimized to not affect the channel structures, thereby reducing or preventing a leakage current, and improving a yield of a semiconductor device.

Furthermore, by expanding a width of the separation region corresponding to a boundary between the channel structures and the support structures, electric field concentration may be alleviated to reduce or prevent an occurrence of an over-etched region, and an area without a vertical structure between the dummy channel structure and the separation region may be reduced or minimized, thereby reducing risk of a stack structure collapsing or preventing a stack structure from collapsing. Accordingly, a semiconductor device having improved reliability and yield may be provided.

Various advantages and effects of embodiments of the present inventive concept are not limited to the foregoing content and may be more easily understood in the process of describing specific example embodiments of the present disclosure. At least some of the above and other features of the invention are set out in the claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of a semiconductor device according to example embodiments;
FIGS. 2A to 2C are schematic cross-sectional views of a semiconductor device according to example embodiments;
FIGS. 3A and 3B are enlarged cross-sectional views of a portion of FIGS. 1 and 2A;
FIGS. 4 to 8 are schematic plan views of a semiconductor device according to example embodiments;
FIG. 9 is a schematic cross-sectional view of a semiconductor device according to example embodiments;
FIGS. 10A to 10K and 11 are schematic cross-sectional views illustrating a method of manufacturing a semiconductor device according to example embodiments
FIG. 12 is a schematic view of a data storage system including a semiconductor device according to example embodiments;
FIG. 13 is a schematic perspective view of a data storage system including a semiconductor device according to an example embodiment; and
FIG. 14 is a cross-sectional view schematically illustrating a semiconductor package according to an example embodiment.

### DETAILED DESCRIPTION

Hereinafter, example embodiments of the present disclosure will be described with reference to the accompanying drawings. Hereinafter, it may be understood that the expressions such as "on," "above," "upper," "below," "beneath," "lower," and "side," may be indicated based on drawings, and in some instances may be indicated by drawing reference numerals and referred to separately. Like reference numbers in the drawings indicate the same or similar functions throughout the various aspects. As used herein, the term "and/or" includes any and all combinations of one or more of the associated listed items. It is noted that aspects described with respect to one embodiment may be incorporated in different embodiments although not specifically described relative thereto. That is, all embodiments and/or features of any embodiments can be combined in any way and/or combination.

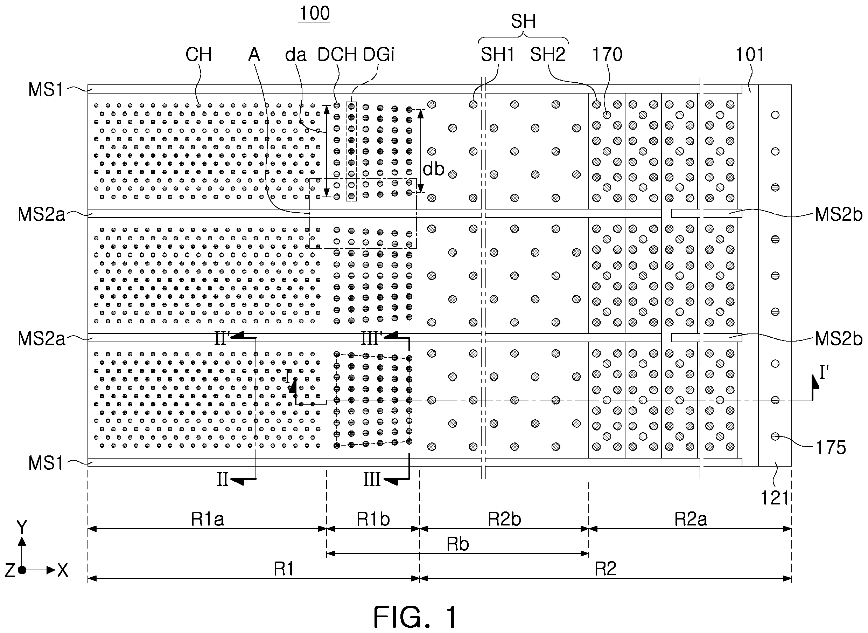

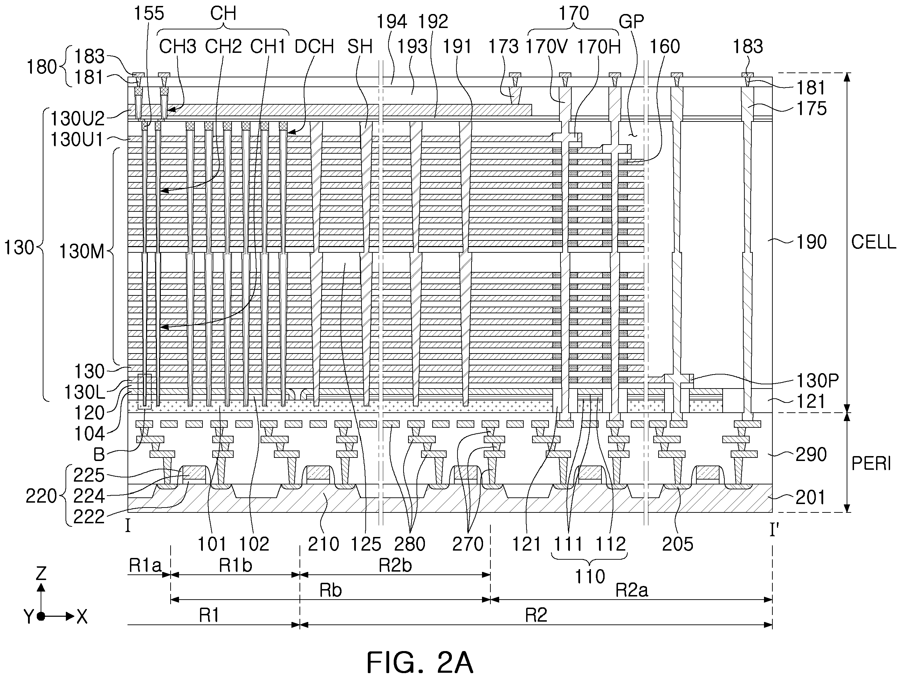

FIG. 1 is a schematic plan view of a semiconductor device according to example embodiments, and FIGS. 2A to 2C are schematic cross-sectional views of a semiconductor device according to example embodiments.

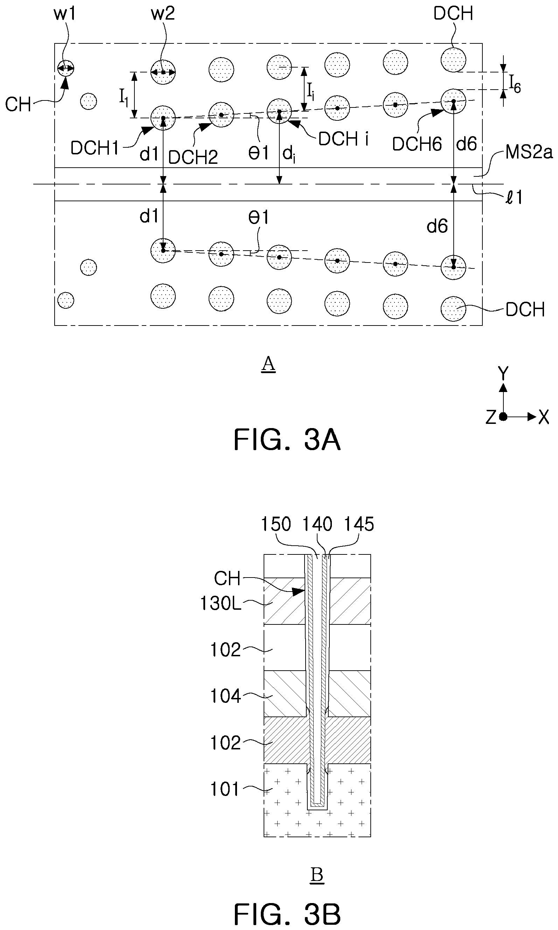

FIGS. 2A to 2C are cross-sectional views taken along cutting lines I -I', II-II', and III-III' of FIG. 1, respectively. FIGS. 3A and 3B are partially enlarged views illustrating partial regions of a semiconductor device according to example embodiments. FIG. 3A is an enlarged view illustrating region 'A' of FIG. 1, and FIG. 3B is an enlarged view illustrating region 'B' of FIG. 2A. FIG. 1 is a view schematically illustrating a plan view of a semiconductor device from a perspective of a lower portion of an upper horizontal insulating layer of FIGS. 2A to 2C to illustrate arrangements of each vertical structure, and FIGS. 2A to 2C illustrate even structures on an upper horizontal insulating layer.

Referring to FIGS. 1 to 3B, a semiconductor device 100 may include a peripheral circuit region PERI, which is a first semiconductor structure including a first substrate 201, and a memory cell region CELL which is a second semiconductor structure including a second substrate 101. The memory cell region CELL may be disposed on the peripheral circuit region PERI. In example embodiments, conversely, the cell region CELL may be disposed below the peripheral circuit region PERI in the Z-direction.

The semiconductor device 100 may include a first region R1 and a second region R2 in a space formed by an X-direction, a Y-direction, and a Z-direction.

The first region R1 of the semiconductor device 100 may include a cell region R1a in which channel structures CH disposed to penetrate or extend through a stack structure of gate electrodes 130 form a zigzag or matrix arrangement, and a first boundary region R1b in which dummy channel structures DCH disposed adjacent to the cell region R1a in the X-direction and disposed to penetrate or extend through the stack structure of the gate electrodes 130 form a plurality of columns.

The second region R2 of the semiconductor device 100 may include a second boundary region R2b adjacent to the first boundary region R1b in the X-direction, in which first support structures SH1 among the support structures SH disposed to penetrate or extend through the stack structure of the gate electrodes 130 are disposed in a zigzag or matrix arrangement, and a connection region R2a adjacent to the second boundary region R2b in the X-direction, in which second support structures SH2 disposed to penetrate or extend through the stack structure of the gate electrodes 130 form a plurality of matrixes. Contact plugs 170 may be disposed between the second support structures SH2 in the connection region R2a.

In other words, in the semiconductor device 100, the cell region R1a, the first boundary region R1b, the second boundary region R2b, and the connection region R2a are sequentially arranged in the X-direction, and a boundary region Rb including a first boundary region R1b and a second boundary region R2b may be disposed between the cell region R1a in which the channel structures CH are disposed and the connection region R2a in which the contact plugs 170 are disposed.

The peripheral circuit region PERI of the semiconductor device 100 may include a first substrate 201 in the first region R1 and the second region R2, source/drain regions 205 and device isolation layers 210 in the first substrate 201, circuit elements 220 disposed on the first substrate 201, circuit contact plugs 270, circuit wiring lines 280, and a peripheral region insulating layer 290.

The first substrate 201 may have an upper surface extending in the X-direction and the Y-direction. An active region may be defined by the device isolation layers 210 in the first substrate 201. The source/drain regions 205 including impurities may be disposed in a portion of the active region. The first substrate 201 may include a semiconductor material, for example, a group IV semiconductor, a group III-V compound semiconductor, or a group II-VI compound semiconductor. The first substrate 201 may be provided as a bulk wafer or an epitaxial layer.

The circuit elements 220 may include a planar transistor. Each of the circuit elements 220 may include a circuit gate dielectric layer 222, a spacer layer 224, and a circuit gate electrode 225. The source/drain regions 205 may be disposed in the first substrate 201 on both sides of the circuit gate electrode 225.

The circuit contact plugs 270 and the circuit wiring lines 280 may form a circuit wiring structure electrically connected to the circuit elements 220 and the source/drain regions 205. The circuit contact plugs 270 may have a cylindrical shape, and the circuit wiring lines 280 may have a line or linear shape. The circuit contact plugs 270 and the circuit wiring lines 280 may include a conductive material, for example, tungsten (W), copper (Cu), aluminum (Al), and/or the like, and each component may further include a diffusion barrier. However, in examples embodiments, the number and arrangement of layers of circuit contact plugs 270 and circuit wiring lines 280 may be variously changed.

The peripheral region insulating layer 290 may be disposed on the first substrate 201 to be on and at least partially cover the circuit element 220. The peripheral region insulating layer 290 may be formed of an insulating material, and may include one or more insulating layers.

The memory cell region CELL of the semiconductor device 100 may include the second substrate 101 in the first region R1 and the second region R2, the gate electrodes 130 stacked on the second substrate 101, interlayer insulating layers 120 alternately stacked with the gate electrodes 130, channel structures CH and dummy channel structures DCH disposed to penetrate or extend through the stack structure of the gate electrodes 130 in the first region R1, the support structures SH disposed to penetrate or extend through the stack structure of the gate electrodes 130 in the second region R2, first and second separation regions MS1, MS2a and MS2b extending to penetrate through the stack structure of the gate electrodes 130, and the contact plugs 170 connected to pad regions 130P of the gate electrodes 130 in the second region R2 and extending in a vertical direction, i.e., Z-direction.

The channel structures CH penetrating or extending through the stack structure of the gate electrodes 130 may be disposed in a zigzag or matrix arrangement in the cell region R1a of the first region R1, and the dummy channel structures DCH disposed to penetrate or extend through the stack structure of the gate electrodes 130 in the first boundary region R1b may be disposed by forming a plurality of columns.

Among the support structures SH penetrating or extending through the stack structure of the gate electrodes 130 in the second boundary region R2b of the second region R2, the first support structures SH1 may be disposed in a zigzag or matrix arrangement, and in the connection region R2a, the second support structures SH2 penetrating or extending through the stack structure of the gate electrodes 130 may be disposed by forming a plurality of matrixes. The contact plugs 170 may be disposed between the second support structures SH2.

The memory cell region CELL may further include a substrate insulating layer 121 on the second substrate 101, first and second horizontal conductive layers 102 and 104 disposed below (in the Z-direction) the gate electrodes 130 in the first region R1, a horizontal insulating layer 110 disposed below (in the Z-direction) the gate electrodes 130 in the second region R2, through-vias 175 extending from the memory cell region CELL to the peripheral circuit region PERI, support structures SH including channel structures CH, dummy channel structures DCH, first support structures SH1 and second support structures SH2, and a cell region insulating layer 190 on and at least partially covering the contact plugs 170 and the gate electrodes 130.

The cell region R1a of the semiconductor device 100 is a region in which the gate electrodes 130 are vertically stacked and the channel structures CH are disposed, and may be a region in which memory cells are disposed. The first boundary region R1b of the semiconductor device 100 may be a buffer region in which the dummy channel structures DCH are disposed. The dummy channel structure DCH has substantially the same configuration as the channel structure CH, and may be a structure that is electrically floated to not function as the channel structure CH. Accordingly, the dummy channel structure DCH may not function as memory cells. The second boundary region R2b of the semiconductor device 100 is a boundary region in which the first support structures SH1 are disposed, and may function as a kind of buffer region. The connection region R2a is a region for electrically connecting the memory cells to the peripheral circuit region PERI, and may perform an electrical connection between the pad region 130P of the gate electrodes 130 and the peripheral circuit region PERI by the contact plugs 170. To this end, the gate electrodes 130 may extend to different lengths, but embodiments of the present disclosure are not limited thereto.

As described above, in at least one direction, for example, in the X-direction, the second region R2 may be disposed in one end of the first region R1, and specifically, the cell region R1a, the first boundary region R1b, the second boundary region R2b, and the connection region R2a may be sequentially disposed.

The second substrate 101 has a plate layer shape and may function as at least a portion of a common source line of the semiconductor device 100.

The second substrate 101 may have an upper surface extending in the X-direction and the Y-direction. The second substrate 101 may include a semiconductor material, for example, a group IV semiconductor, a group III-V compound semiconductor, and/or a group II-VI compound semiconductor. For example, the group IV semiconductor may include silicon, germanium, and/or silicon-germanium. The second substrate 101 may further include impurities. The second substrate 101 may be provided as a polycrystalline semiconductor layer such as a polycrystalline silicon layer or an epitaxial layer.

The first and second horizontal conductive layers 102 and 104 may be sequentially stacked and disposed on the upper surface of the first region R1 of the second substrate 101. The first horizontal conductive layer 102 may not extend into the second region R2 of the second substrate 101, and the second horizontal conductive layer 104 may extend into the second region R2. The first horizontal conductive layer 102 may function as a portion of a common source line of the semiconductor device 100, for example, as a common source line together with the second substrate 101. As illustrated in an enlarged view of FIG. 3B, the first horizontal conductive layer 102 may be directly connected to a channel layer 140 around the channel layer 140.

The second horizontal conductive layer 104 may be in contact with the second substrate 101 in a boundary between the first region R1 and the second region R2 in which the first horizontal conductive layer 102 and the horizontal insulating layer 110 are not disposed. The second horizontal conductive layer 104 may be bent in the boundary between the first region R1 and the second region R2 while being on and at least partially covering an end of the first horizontal conductive layer 102 or the horizontal insulating layer 110 and extending onto the second substrate 101.

The first and second horizontal conductive layers 102 and 104 may include a semiconductor material, for example, polycrystalline silicon. In this example, at least the first horizontal conductive layer 102 may be a layer doped with impurities of the same conductivity type as the second substrate 101, and the second horizontal conductive layer 104 may be a doped layer or a layer including impurities diffused from the first horizontal conductive layer 102. However, the material of the second horizontal conductive layer 104 is not limited to the semiconductor material, and may be replaced with an insulating layer.

The horizontal insulating layer 110 may be disposed on the second substrate 101 on the same level in the Z-direction as the first horizontal conductive layer 102 in at least a portion of the second region R2 and the first region R1. The horizontal insulating layer 110 may include first and second horizontal insulating layers 111 and 112 alternately stacked in the second region R2 of the second substrate 101. The horizontal insulating layer 110 may be layers that remain after a portion of the horizontal insulating layer 110 is replaced with the first horizontal conductive layer 102 in a manufacturing process of the semiconductor device 100.

The horizontal insulating layer 110 may include silicon oxide, silicon nitride, silicon carbide, and/or silicon oxynitride. The first horizontal insulating layers 111 and the second horizontal insulating layer 112 may include different insulating materials. For example, the first horizontal insulating layers 111 may be formed of the same material as the interlayer insulating layers 120, and the second horizontal insulating layer 112 may be formed of a material different from the interlayer insulating layers 120.

The substrate insulating layer 121 may be disposed to penetrate through the second substrate 101, the horizontal insulating layer 110, and the second horizontal conductive layer 104 in the connection region R2a of the second region R2. The substrate insulating layer 121 may be further disposed in the first region R1 or the second region R2, for example, in a region in which the through-vias 175 are disposed. A lower surface of the substrate insulating layer 121 may be coplanar with a lower surface of the second substrate 101 or may be disposed on a lower level in the Z-direction than the lower surface of the second substrate 101. The substrate insulating layer 121 may include an insulating material, for example, silicon oxide, silicon nitride, silicon carbide, and/or silicon oxynitride.

The gate electrodes 130 may be spaced apart from each other on the second substrate 101 in a vertical direction (Z-direction) to form a stack structure. The gate electrodes 130 may include a lower gate electrode 130L forming a gate of a ground selection transistor and memory gate electrodes 130M forming a plurality of memory cells, and a first upper gate electrode 130U1 and a second upper gate electrode 130U2 on the memory gate electrodes 130M. The number of memory gate electrodes 130M forming the memory cells may be determined according to the capacitance of the semiconductor device 100. According to an example embodiment, one or two or more upper and lower gate electrodes 130U1, 130U2 and 130L may be provided, and may have the same or different structure as the memory gate electrodes 130M. In example embodiments, the second upper gate electrode 130U2 may form string selection transistors, and the first upper gate electrode 130U1 may form an erase transistor used in an erase operation using a gate induced drain leakage current (GIDL) phenomenon. The erase transistor may be included even in a lower portion of a lower gate electrode, but embodiments of the present disclosure are not limited thereto.

Furthermore, some gate electrodes 130M, for example, gate electrodes 130M adjacent to the first upper or lower gate electrodes 130U1 and 130L may be dummy gate electrodes.

As illustrated in FIG. 1, the gate electrodes 130 may be disposed to be separated from each other in the Y-direction by the first separation regions MS1 continuously extending in the first region R1 and the second region R2. The gate electrodes 130 between a pair of first separation regions MS1 may form one memory block, but the scope of the memory block is not limited thereto. Some gate electrodes 130, for example, memory gate electrodes 130M, may form one layer in one memory block, respectively.

The gate electrodes 130 may be stacked spaced apart from each other in the first region R1 and the second region R2 in the vertical direction (Z-direction), and may extend from the first region R1 to the second region R2 by different lengths to form a stepped structure GP having a stepwise shape in a portion of the second region R2, for example, the connection region R2a. The gate electrodes 130 may be disposed to have a stepped structure with each other even in the Y-direction. By the stepped structure, an upper gate electrode 130 may extend to be longer than an upper gate electrode 130, and accordingly, the gate electrodes 130 may have regions in which upper surfaces thereof are exposed upward from the interlayer insulating layers 120 and other gate electrodes 130, respectively, and the regions may be referred to as pad regions 130P. In each gate electrode 130, the pad region 130P may be a region including an end of the gate electrode 130 in the X-direction. The pad area 130P may correspond to one region of the gate electrode 130 disposed at an uppermost portion in each region, among the gate electrodes 130 forming the stack structure in the connection region R2a of the second region R2. The gate electrodes 130 may be connected to the contact plugs 170 in the pad regions 130P, respectively. The gate electrodes 130 may have thicknesses increased in the pad regions 130P.

The gate electrodes 130 may include a metallic material, such as tungsten (W). According to an example embodiment, the gate electrodes 130 may include polycrystalline silicon and/or a metal silicide material. In example embodiments, the gate electrodes 130 may further include a diffusion barrier, and for example, the diffusion barrier layer may include tungsten nitride (WN), tantalum nitride (TaN), titanium nitride (TiN), or a combination thereof.

The interlayer insulating layers 120 may be disposed between the gate electrodes 130. Similarly with the gate electrodes 130, the interlayer insulating layers 120 may be disposed to be spaced apart from each other in a direction, perpendicular to an upper surface of the second substrate 101, and extend in the X-direction. The interlayer insulating layers 120 may include an insulating material, such as silicon oxide or silicon nitride.

The first and second separation regions MS1, MS2a and MS2b may be disposed to penetrate or extend through at least a portion of the gate electrodes 130 and extend in the X-direction. The first and second separation regions MS 1, MS2a and MS2b may be disposed in parallel with each other. The first and second separation regions MS1, MS2a and MS2b may penetrate through entire gate electrodes 130 stacked on the second substrate 101, and further penetrate or extend through the first and second horizontal conductive layers 102 and 104 and the horizontal insulating layer 110 at the bottom, thus coming into contact with the second substrate 101. The first separation regions MS1 extend into one in the X-direction, and the second separation regions MS2 may intermittently extend between a pair of first separation regions MS1 or may be disposed only in a partial region. For example, second central separation regions MS2a may extend into one within the first region R1, and may pass through the second boundary region R2b of the second region R2, and intermittently extend in the X-direction within the connection region R2a. Second auxiliary separation regions MS2b may be disposed only in a portion of the second region R2, for example, in the connection region R2a, and may be spaced apart from the second central separation regions MS2a by a predetermined distance and may face the second central separation regions MS2a and extend in the X-direction. The first separation regions MS 1 and the second central separation regions MS2a continuously extend within the first region R1 and the second boundary region R2a, and are not interrupted. However, in example embodiments, the arrangement order and the number of first and second separation regions MS1, MS2a and MS2b are not limited to those illustrated in FIG. 1

A separation insulating layer 105 may be disposed in the first and second separation regions MS1, MS2a and MS2b. The separation insulating layer 105 may have a shape in which a width thereof is reduced toward the second substrate 101 due to a high aspect ratio, but the present disclosure is not limited thereto, and the separation insulating layer 105 may have a side surface, perpendicular to an upper surface of the second substrate 101. A lower surface of the separation insulating layer 105 may be in contact with the second substrate 101.

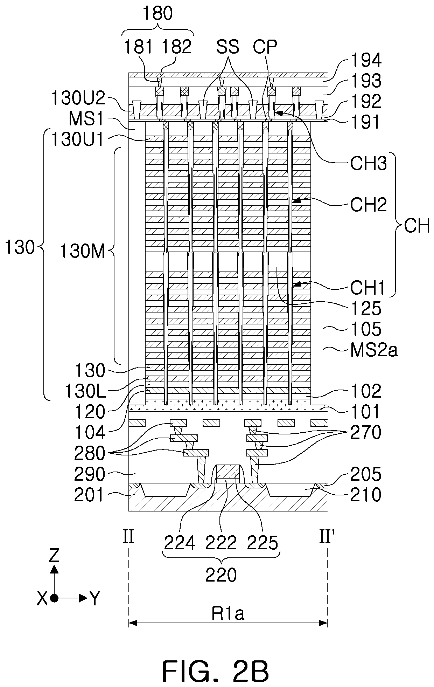

Upper separation regions SS may extend in the X-direction between the first and second separation regions MS1, MS2a and MS2b adjacent to each other. The upper separation regions SS may be disposed in a portion of the second region R2 and in the first region R1. The upper separation regions SS may penetrate or extend through a second upper gate electrode 130U2 disposed on an uppermost portion among the gate electrodes 130. As illustrated in FIG. 2B, the upper separation regions SS may divide the second upper gate electrode 130U2 in the Y-direction.

The upper separation regions SS may include upper separation insulating layers, respectively. An upper separation insulating layer may include an insulating material, for example, silicon oxide, silicon nitride, and/or silicon oxynitride.

Each of the channel structures CH may form one memory cell string, and may be spaced apart from each other while forming rows and columns in the cell region R1a of the first region R1. The channel structures CH may be arranged in a zigzag shape in one direction in an X-Y plane. The channel structures CH may be symmetrically disposed about the first separation regions MS1 or the second central separation regions MS2a in the X-direction in the cell region R1a. For example, when the channel structures CH disposed between two first separation regions MS1 spaced apart from each other in the Y-direction and the second central separation regions MS2a have an odd number of columns, arrangements of the channel structures CH on both sides with each of the first separation regions MS1 or the second central separation regions MS2a as an axis may be the same as each other, and the channel structures CH on both sides of the same arrangement may be symmetrical to each other about the first separation regions MS1 or the second central separation regions MS2a in the X-direction.

When the channel structures CH disposed between two first separation regions MS1 spaced apart from each other in the Y-direction or the second central separation regions MS2a have an even number of columns, arrangements of the channel structures CH on both sides with each of the first separation regions MS1 or the second central separation regions MS2a as an axis may be different from each other, and the channel structures CH on both sides of the different arrangements may form a mirror pair to be symmetrical to each other about the first separation regions MS1 or the second central separation regions MS2a.

Each of the channel structures CH may include first, second, and third channel structures CH1, CH2 and CH3 vertically stacked, and the first and second channel structures CH1 and CH2 may have a column shape and may be connected to each other, and the second channel structure and the third channel structures CH2 and CH3 may be connected to each other by a conductive connection pad CP.

The first and second channel structures CH1 and CH2 may have inclined side surfaces that become narrower as they approach the second substrate 101 depending on an aspect ratio thereof.

The first channel structures CH1 and the upper second channel structures CH2 may have bent portions due to a difference in width in the connection region. However, according to example embodiments, the number of channel structures CH stacked in the Z-direction may be variously changed.

Each of the first channel structures CH1 and the upper second channel structures CH2 may include a channel layer 140 disposed in a channel hole, a gate dielectric layer 145, a gate dielectric layer 145, a channel buried insulating layer 150, and a channel pad 155. As illustrated in an enlarged view of FIG. 3A, the channel layer 140 may be formed in an annular shape at least partially surrounding in the X-Y plane the channel buried insulating layer 150 therein, but according to an example embodiment, the channel layer 140 may have a column shape such as a cylinder or a prismatic column without the channel buried insulating layer 150. The channel layer 140 may be connected to the first horizontal conductive layer 102 at the bottom. The channel layer 140 may include a semiconductor material, such as polycrystalline silicon and/or single crystalline silicon.

The gate dielectric layer 145 may be disposed between the gate electrodes 130 and the channel layer 140. Although not specifically illustrated, the gate dielectric layer 145 may include a tunneling layer, a charge storage layer, and a blocking layer sequentially stacked from the channel layer 140. The tunneling layer may tunnel electric charges to the charge storage layer, and may include, for example, silicon oxide (SiO₂), silicon nitride (Si₃N₄), silicon oxynitride (SiON), or a combination thereof. The charge storage layer may be a charge trap layer or a floating gate conductive layer. The blocking layer may include silicon oxide (SiO₂), silicon nitride (Si₃N₄), silicon oxynitride (SiON), a high dielectric constant (high-x) dielectric material, or a combination thereof. In example embodiments, at least a portion of the gate dielectric layer 145 may extend along the gate electrodes 130 in a horizontal direction, e.g., Y-direction.

The channel pad 155 may be disposed only on an upper end of the second channel structure CH2 at the top. The channel pad 155 may include, for example, doped polycrystalline silicon.

The channel layer 140, the gate dielectric layer 145, and the channel buried insulating layer 150 may be connected to each other between the first channel structure CH1 and the second channel structure CH2. An upper interlayer insulating layer 125 having a relatively large thickness may be disposed between the first channel structure CH1 and the second channel structure CH2. However, thicknesses and shapes of the interlayer insulating layers 120 and the upper interlayer insulating layer 125 may be variously changed in example embodiments.

The third channel structures CH3 may penetrate or extend through the second upper gate electrode 130U2 and extend in the Z-direction, and may be connected to the second channel structures CH2, respectively. The third channel structures CH3 may be disposed on the second channel structures CH2, respectively, and may be shifted from the second channel structures CH2 in a horizontal direction, e.g., Y-direction, but the present disclosure is not limited thereto.

Each of the third channel structures CH3 may include an upper channel layer 140U, an upper gate dielectric layer 145U, an upper channel buried insulating layer 150U, and an upper channel pad 155U, which is disposed in an upper channel hole. The upper channel layer 140U may be formed in an annular shape at least partially surrounding in the X-Y plane the upper channel buried insulating layer 15OU therein. The upper channel layer 140U may be connected to the connection pad CP at the bottom, and may be electrically connected to the channel layer 140 of the second channel structure CH2 through the connection pad CP.

The above-described descriptions of each of the channel layer 140, the gate dielectric layer 145, the channel buried insulating layer 150, and the channel pad 155 may be identically applied to the materials of the upper channel layer 140U, the upper gate dielectric layer 145U, the upper channel buried insulating layer 150U, and the upper channel pad 155U. The connection pad CP may include a conductive material, for example, polycrystalline silicon.

The dummy channel structures DCH are dummy channels that do not substantially form a memory cell string, and may be referred to as dummy vertical structures or support structures.

The dummy channel structures DCH have the same structure as the channel structures CH, and may be disposed to be spaced apart from each other while forming a plurality of columns in the first boundary or buffer region R1b of the first region R1. The dummy channel structures DCH are disposed in a form of sequentially forming columns in the Y-direction in the X-Y plane. A plurality of dummy channel structures DCH forming each column of the dummy channel structures DCH may be defined as an ith dummy group DGi (i=1,...,n).

The ith dummy group DGi may include dummy channel structures DCHi disposed on both ends in the Y-direction, and a distance between the dummy channel structures DCHi on both ends of the ith dummy group DGi may be defined as a length (da, ..., db) of the ith dummy group DGi.

A minimum distance between the dummy channel structure DCHi (i=1,..., n) on any one of both ends of the ith dummy group DGi and the first separation regions MS1 or the second central separation regions MS2a adjacent to the dummy channel structure DCHi on one end may be defined as a separation distance di (i=1, 2,...n) between the ith dummy group DGi and the separation regions MS1 and MS2a.

The dummy channel structures DCH may be disposed such that a separation distance di (i = 1, 2, ..., n) between the separation regions MS1 and MS2a adjacent to the ith dummy group DGi is variable, between the two separation regions MS1 and MS2a adjacent to each other in the Y-direction.

More specifically, referring to FIG. 3A, a minimum distance from a center line (central axis) 11 extending in the X-direction along a center of a width of the first separation regions MS 1 or the second central separation regions MS2a in the Y-direction to a center of the dummy channel structure DCHi on one end of each ith dummy group DGi, may be defined as a separation distance di, and the separation distance di may increase as it approaches the second boundary region R2b, that is, as it approaches the support structures SH.

In the first boundary region R1b, the separation distance di may increase as it approaches from the cell region Ra1 to the second boundary region R2b, and a change in the separation distance di may be simultaneously satisfied in the dummy channel structure DCHi on both ends. That is, in one dummy group DGi, a separation distance di with respect to a dummy channel structure DCHi of one end may be equal to a separation distance di with respect to a dummy channel structure DCHi of the other end, and an arrangement of the dummy channel structures DCH may be trapezoidal as illustrated in FIG. 1.

As for a length of one dummy group DGi, a length da of a first dummy group close to the cell region R1a is longest due to a change in the separation distance di of the dummy channel structures DCH, and a length db of a last nth column, i.e. a nth dummy group DGn close to the second boundary region R2b, is the shortest, and as any one of the dummy groups DGi between the first dummy group DG1 and the nth dummy group DGn approaches the nth dummy group DGn, the length of the dummy group DGi may be reduced.

The separation distance di of each dummy group DGi may gradually increase from the cell region Ra1 to the second boundary region R2b. The gradual increasing may be defined as having a constant slope Θ1 with respect to the center line l1 of the first separation regions MS 1 or the second central separation regions MS2a of a trapezoidal inclined side. That is, a change amount of a separation distance dᵢ₋₁ of a previous dummy group dummy group DGᵢ₋₁ and the separation distance di of a current dummy group DGi may be the same as a change amount of the separation distance di of the current dummy group DGi and a separation distance dᵢ₊₁ of a next dummy group DGᵢ₊₁.

Furthermore, a relationship of separation distances d1 to dn between a plurality of dummy groups DG1 to DGn may be defined according to a distance between the plurality of dummy groups DG1 to DGn in the X-direction.

That is, a ratio in a value of a difference di-d1 between separation distances between the first dummy group DG1 and the ith dummy group DGi with respect to a distance between the first dummy group DG1 and the ith dummy group DGi in the X-direction may be equal to a ratio in a value of a difference dn-di between separation distances between the nth dummy group DGn and the ith dummy group DGi with respect to a distance between the nth dummy group DGn and the ith dummy group DGi in the X-direction. The ratio with respect to the separation distance between the dummy groups DG1 to DGn may be identically applied to a length (da,..., db) of the dummy groups DG1 to DGn.

When the lengths da and db of each dummy group DGi decreases with the same ratio, as illustrated in FIG. 1, the number of dummy channel structures DCH forming each dummy group DGi may be identical to each other, and an interval Ii (i=1, ..., n) between the dummy channel structures DCH of each dummy group DGi may decrease toward the second boundary region R2b.

That is, an interval between the dummy channel structures DCH may gradually decrease so that an interval I1 between the dummy channel structures DCH of the first dummy group DG1 is the largest, and a distance In (e.g., n=6) between the dummy channel structures DCH of a last dummy group DGn is the smallest.

A dummy channel structure DCHn on one end of the last dummy group DGn is disposed to have a largest separation distance dn from first separation regions MS1 or second central separation regions MS2a adjacent to each other, and may be disposed to have a separation distance dn greater than a reference distance from the separation insulating layer 105 disposed between the first support structure SH1.

The reference distance may vary, depending on widths of the first separation regions MS1 or the second central separation regions MS2a in the Y-direction, and may be a distance in which at least 180 nm is added to 1/2 of the width in the Y-direction, in some embodiments at least 190 nm is added thereto, and in further embodiments at least 192 nm is added thereto. That is, the dummy channel structure DCHn on one end of the last dummy group DGn may be disposed to be spaced apart from an external side surface of the first separation regions MS1 or the second central separation regions MS2a adjacent to each other by at least 180 nm, in some embodiments 190 nm or more, and further embodiments 192 nm or more.

In this manner, when the dummy channel structures DCH are arranged to form openings for the separation regions MS1 and MS2a between the conductive channel layer and the non-conductive support structure SH, plasma over-etching due to electric field concentration by a difference in conductivity between a conductive channel layer and a non-conductive insulating layer may be reduced or minimized.

The dummy channel structures DCHs disposed on both sides in the Y-direction with the first separation regions MS1 or the second central separation regions MS2a in the X-direction as an axis in the second boundary region R2b may be symmetrical to each other. For example, the dummy channel structures DCH between the first separation regions MS1 and the second central separation regions MS2a adjacent to each other are disposed to have a trapezoidal shape, and opposite dummy channel structures DCH may also be disposed to have a trapezoidal shape with the first separation regions MS1 or the second central separation regions MS2a in the X-direction as an axis, and the two trapezoidal arrangements may be symmetrical to each other with the first separation regions MS 1 or the second central separation regions MS2a in the X-direction as an axis.

An arrangement of the channel structures CH and the dummy channel structures DCH between the two adjacent first separation regions MS1 and second central separation regions MS2a may be different from each other.

As illustrated in FIG. 1, the channel structures CH may be disposed in a zigzag fashion in one direction, and the dummy channel structures DCH may form a plurality of columns in the Y-direction and may be disposed in a trapezoidal shape. Furthermore, a density of the channel structures CH may be greater than that of the dummy channel structures DCH.

A shape and an internal configuration of each dummy channel structure DCH may be the same as those of the channel structure CH, but a size of the dummy channel structures DCH may be larger than that of the channel structures CH.

Specifically, a diameter W2 or a largest width of the dummy channel structures DCH may be greater than a diameter W1 or a largest width of the channel structures CH.

For example, the diameter W2 of the dummy channel structures DCH may be 90 to 100 nm, in some embodiments 95 nm, and the diameter W1 of the channel structures CH may be 80 to 90 nm, in some embodiments 85 nm, but embodiments of the present disclosure are not limited thereto.

The dummy channel structures DCH may include first and second dummy channel structures vertically stacked in the Z-direction, and a shape thereof may be described as being identical to the shape of the first and second channel structures CH1 and CH2, but embodiments of the present disclosure are not limited thereto.

The support structures SH disposed in the second region R2 may include first support structures SH1 disposed in the second boundary region R2b and second support structures SH2 disposed in the connection region R2a.

The first support structures SH1 and the second support structures SH2 may have the same configuration, but embodiments of the present disclosure are not limited thereto.

The first support structures SH1 disposed in the second boundary region R2b close to the first boundary region R1b in the X-direction may form rows and columns and may be spaced apart from each other.

In the second boundary region R2b, the contact plugs 170 may not be disposed, and the gate electrodes 130 may not be formed to have a step portion, and the second boundary region R2b may include a structure in which all the gate electrodes 130 are stacked in a Z-direction, similar to the first boundary region R1b.

A boundary region Rb including the first boundary region R1b and the second boundary region R2b may be a buffer region between the contact plugs 170 and the channel structures CH functioning as memory cells. The first support structures SH1 in the second boundary region R2b and the second support structures SH2 in the connection region R2a may have different arrangements.

As illustrated in FIG. 1, the first support structures SH1 may be disposed in a zigzag or matrix arrangement in the second boundary region R2b, and respective intervals thereof may be identical to each other.

A separation distance between the first region R1 and the second region R2, specifically, a separation distance dn from the first separation regions MS 1 or the second central separation regions MS2a to the last dummy group DGn between the first boundary region R1b and the second boundary region R2b may be greater than a separation distance to the first support structure SH1 adj acent to the first boundary region R1b, but embodiments of the present disclosure are not limited thereto.

A plurality of first support structures SH1 may be symmetrical to each other with the first separation regions MS 1 or the second central separation regions MS2a in the X-direction as an axis (central line li).

In the connection region R2a of the second region R2, the second support structures SH2 may be spaced apart from each other while forming rows and columns. As illustrated in the plan view of FIG. 1, the second support structures SH2 may be disposed to surround each of the contact plugs 170 in four directions. However, in example embodiments, an arrangement form of the second support structures SH2 may be variously changed.

An arrangement of the first support structures SH1 between the first separation regions MS 1 and the second central separation regions MS2a adj acent to each other and an arrangement of the second support structures SH2 adjacent to the first support structures in the X-direction may be different from each other, and the second support structures SH2 may be disposed at a greater density, but embodiments of the present disclosure are not limited thereto.

Arrangements of the channel structures CH, the dummy channel structures DCH, and the first support structures SH1 between the two adjacent first separation regions MS1 or second central separation regions MS2a may be different from each other.

The first and second support structures SH1 and SH2 may have a column shape and may have inclined side surfaces that become narrower as they approach the second substrate 101 depending on an aspect ratio.

The support structures SH may include two vertically stacked support structures SH. The support structures SH may have a form in which the lower support structures and the upper support structures are connected, and may have a bent portion due to a difference in width in the connection region. However, according to example embodiments, the number of support structures stacked in the Z-direction may be variously changed. A diameter or a maximum width of the first and second support structures SH1 and SH2 may be greater than that of the dummy channel structures DCH. The first and second support structures SH1 and SH2 may have a circular shape, an elliptical shape, or a similar shape thereof in the X-Y plane.

The first and second support structures SH1 and SH2 may have internal structures different from those of the channel structures CH or the dummy channel structures DCH. Because the first and second support structures SH1 and SH2 do not include a channel layer, they need not include a conductive material, and may include a support insulating layer 160 disposed in each support hole. The support insulating layer 160 may include, for example, silicon oxide, silicon nitride, and/or silicon oxynitride, as an insulating material.

The contact plugs 170 may be connected to the contact regions 130P of the gate electrodes 130 disposed on an uppermost portion in the connection region R2a. The contact plugs 170 may have a shape corresponding to the channel structures CH. Each of the contact plugs 170 includes a lower region and an upper region penetrating or extending through stack structures, respectively, and may have a bent portion whose width is discontinuous changed below the upper horizontal insulating layer 250. The lower region may further penetrate through the substrate insulating layer 121. The lower region and the upper region may have a cylindrical shape whose width decreases toward the substrate 201 due to the aspect ratio. Each of the contact plugs 170 may further include a landing region whose width is expanded below the substrate insulating layer 121. However, in some example embodiments, the contact plugs 170 may not include the landing region.

The contact plugs 170 may penetrate or extend through at least a portion of the cell region insulating layer 190 and may be connected to each of the contact regions 130P of the gate electrodes 130 exposed to the top. The contact plugs 170 may penetrate or extend through the gate electrodes 130 below the contact regions 130P and penetrate or extend through the second horizontal conductive layer 104, the horizontal insulating layer 110, and the second substrate 101, and may be connected to the circuit wiring lines 280 in the peripheral circuit region PERI. The contact plugs 170 may be spaced apart from the gate electrodes 130 below the contact regions 130P by the contact insulating layers 160. The contact plugs 170 may be spaced apart from the second substrate 101, the horizontal insulation layer 110, and the second horizontal conductive layer 104 by substrate insulation layers 121.

Each of the contact plugs 170 may have a shape horizontally expanded in the contact region 130P. The contact plug 170 may include a vertical extension portion 170V extending in the Z-direction and a horizontal extension portion 170H horizontally extending from the vertical extension portion 170V to come into contact with the gate electrode 130. The horizontal extension portion 170H may be disposed along a circumference of the vertical extension portion 170V, and an entire side surface thereof may be surrounded by the gate electrode 130. A distance from a side surface of the vertical extension portion 170V to an end of the horizontal extension portion 170H may be less than a distance from the side surface of the vertical extension portion 170V to external surfaces of the contact insulating layers 160. The contact plugs 170 may be spaced apart from the gate electrodes 130 below the contact regions 130P, that is, gate electrodes 130 not electrically connected, by the contact insulating layers 160.

The contact plugs 170 may include one or more conductive materials, such as tungsten (W), copper (Cu), aluminum (Al), and an alloy thereof. In some example embodiments, the contact plugs 170 may include a barrier layer extending along a side surface and a bottom surface thereof, or may have an air gap therein.

The contact insulating layers 160 may be disposed below the contact regions 130P in the Z-direction to at least partially surround a side surface of each of the contact plugs 170 in the X-Y plane. The contact insulating layers 160 may be disposed around each of the contact plugs 170 to be spaced apart from each other in the Z-direction. The contact insulating layers 160 may be disposed on substantially the same level as each of the gate electrodes 130. The contact insulating layers 160 may include an insulating material, for example, silicon oxide, silicon nitride, and/or silicon oxynitride.

The upper contact plug 173 may be connected to the second upper gate electrode 130U2. Unlike the contact plugs 170, the upper contact plug 173 may not penetrate through the second upper gate electrode 130U2. The upper contact plug 173 may be disposed to partially recess the second upper gate electrode 130U2 from an upper surface thereof, or may be disposed to be connected to the upper surface thereof. The upper contact plug 173 may include a conductive material, and may include the same material as the contact plugs 170, but embodiments of the present disclosure are not limited thereto.

Through-vias 175 may be disposed outside the second substrate 101, and may be extended to the peripheral circuit region PERI by penetrating or extending through the memory cell region R1a. The through-vias 180 may be disposed to connect upper wirings 185 of the memory cell region R1a to circuit wiring lines 280 of the peripheral circuit region PERI. However, according to example embodiment, the through-vias 175 may be disposed to penetrate or extend through a stack structure of sacrificial insulating layers 118 and interlayer insulating layers 120, in a region in which the sacrificial insulating layers 118 not replaced with the gate electrodes 130 remain. A shape of the through-vias 175 may be formed to have a bent portion in the same manner as the contact plugs 170. The through-vias 175 may include one or more conductive materials, such as tungsten (W), copper (Cu), aluminum (Al), and an alloy thereof.

The cell region insulating layer 190 may be disposed to be on and at least partially cover the second substrate 101, the gate electrodes 130 on the second substrate 101, and the peripheral region insulating layer 290. The cell region insulating layer 190 may be formed of an insulating material, or may be formed of a plurality of insulating layers.

An upper horizontal insulating layer 191 may be further formed on the cell region insulating layer 190. The upper horizontal insulating layer 191 may be disposed on the channel structures CH, the dummy channel structures DCH, and the support structures SH. The upper horizontal insulating layer 191 may be disposed on a higher level in the Z-direction than the stack structure and the cell region insulating layer 190. The upper horizontal insulating layer 191 may have a conformal thickness and may be disposed to extend in the X-direction and the Y-direction. A thickness of the upper horizontal insulating layer 191 may be substantially the same as or less than the thickness of the gate electrode 130. The upper horizontal insulating layer 191 may include a material different from that of the cell region insulating layer 190. The upper horizontal insulating layer 191 may include a material having etching selectivity with respect to the cell region insulating layer 190. For example, the upper horizontal insulation layer 191 may include one or more nitride-based materials, such as silicon nitride and silicon oxynitride. The connection pad CP may penetrate or extend through the upper horizontal insulating layer 191 to be connected to the channel structures CH. The connection pad CP may be a structure at least partially filled in a plurality of holes having a shape such as a circle, an ellipse, and a polygon. In the Z-direction, which is the vertical direction, the connection pad CP may partially overlap the second channel structures CH2. A partial region of each of the second channel structures CH2 may overlap the connection pad CP, and the remaining region may overlap the upper horizontal insulating layer 191. That is, on a plane, a center of the connection pad CP may be spaced apart from a center of each of the second channel structures CH2.

A first insulating layer 192 may be disposed on the upper surface of the upper horizontal insulating layer 191. The first insulating layer 192 may have a thickness greater than that of the upper horizontal insulating layer 191. The first insulating layer 192 may include a material having etching selectivity with respect to the upper horizontal insulating layer 191. The first insulating layer 192 may include, for example, silicon oxide.

The second upper gate electrode 130U2, that is, an upper electrode, may be provided on the first insulation layer 192. The second upper gate electrode 130U2 may partially overlap the stack structure in the Z-direction. The second upper gate electrode 130U2 may be disposed on the first region R1. According to example embodiments, the second upper gate electrode 130U2 may extend to the second region R2 and may be disposed on some support structures SH.

The second upper gate electrode 130U2 may be separated into a plurality of second upper gate electrodes 130U2 by an upper insulating region SS. The separated second upper gate electrodes 130U2 may be spaced apart from each other in the Y-direction with the upper insulating region SS interposed therebetween. Each of the separated second upper gate electrodes 130U2 may include a string selection line.

The second and third insulating layers 193 and 194 may be sequentially stacked on the second upper gate electrode 130U2. The second and third insulating layers 193 and 194 may include silicon oxide, silicon nitride, and/or silicon oxynitride.

The upper separation regions SS may extend in the X-direction between the first and second separation regions MS1 and MS2a adjacent to each other. The upper separation regions SS may be disposed to penetrate or extend through the second upper gate electrode 130U2 and extend in the X-direction. The upper separation regions SS may penetrate or extend through the upper gate electrode 130U2 and extend into the first insulating layer 192. A lower surface of the upper separation regions SS may be disposed on a higher level in the Z-direction than the upper horizontal insulating layer 191.

An upper separation insulating layer may be disposed in the upper separation regions SS. In an example embodiment, the upper separation insulating layer may include an insulating material, such as silicon oxide. However, according to example embodiments, the upper insulating regions SS may include at least a portion of a material of the third channel structures CH3. For example, each of the insulating regions may include a buried semiconductor pattern and a barrier layer.

The third channel structures CH3 and the connection pad CP may not be disposed on the dummy channel structures DCH in the first region R1, and a stack structure of the upper horizontal insulating layer 191, the first insulating layer 192, an upper gate electrode 131, and the second and third insulating layers 193 and 194 may be disposed on the dummy channel structures DCH in the first boundary region R1b in which the dummy channel structure DCH is disposed.

Accordingly, the configuration of the dummy channel structures DCH may be identical to or similar to that of the channel structures CH, and may be disposed in a floating state in which electrical conduction is blocked so that the dummy channel structures DCH cannot function as a memory cell.

The upper insulating region SS may extend from the cell region R1a into the first boundary region R1b in which the dummy channel structures (DCH) are disposed, but since the upper insulating region SS is not disposed on the same level in the Z-direction as the dummy channel structures DCH, the degree of freedom in the arrangement of the dummy channel structures DCH may be improved.

The upper wiring structure 180 may include a conductive material and may be electrically connected to the upper channel structures CH3. The upper wiring structure 180 may include upper contact plugs 181 and upper wirings 183. The upper contact plugs 181 may penetrate or extend through the third upper insulating layer 194 to come into contact with the third channel structure CH3, each of the contact plugs 170, and upper surfaces of the through-vias 175. The upper wirings 183 may be disposed on the upper contact plugs 181 and the third upper insulating layer 194. Some of the upper wirings 183 may be bit lines in contact with the contact plugs 181. The bit lines may extend in the Y-direction, perpendicular to the X-direction in which the upper separation regions SS extend. Multilayered plugs may be disposed between the upper wirings 183 and the upper contact plugs 181 according to a circuit design, but embodiments of the present disclosure are not limited thereto.

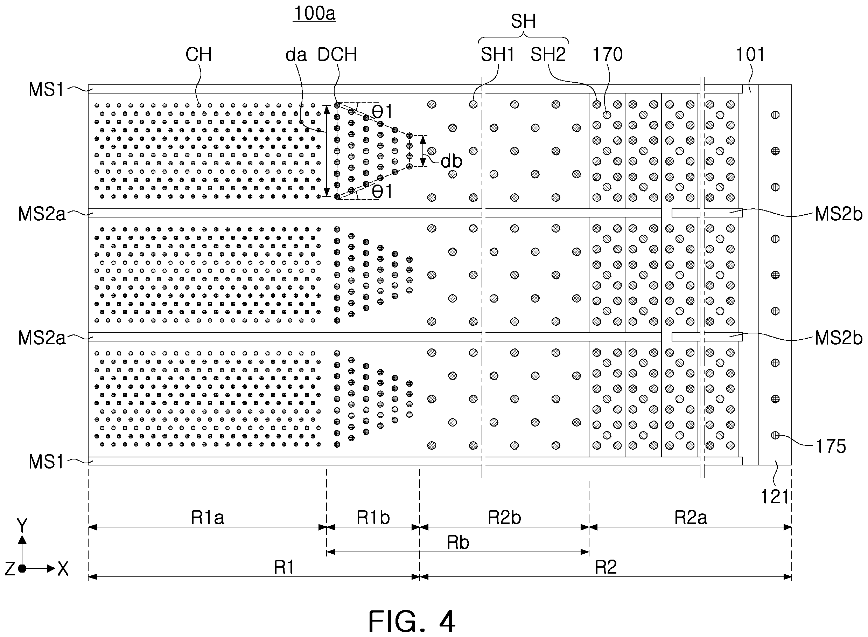

FIGS. 4 to 8 are schematic plan views of a semiconductor device according to example embodiments.

Referring to FIG. 4, in a semiconductor device 100a, dummy channel structures DCH of a first boundary region R1b may form a plurality of columns and may be spaced apart from each other. The dummy channel structures DCH are disposed to form columns in the Y-direction in an X-Y plane, and dummy channel structures DCH in each column may be defined as one dummy group DGi. Each dummy group DGi may include dummy channel structures DCHi on both ends thereof, and may be disposed simultaneously with changing a separation distance di between first separation regions MS1 or second central separation regions MS2a adjacent to a dummy channel structure DCHi on one end thereof.

Specifically, referring to FIG. 4, the separation distance di from a center line 11 extending in the X-direction along a center of widths of the first separation regions MS1 or the second central separation regions MS2a in the Y-direction to the dummy channel structure DCHi on one end of the dummy group DGi may increase as a distance from a second boundary region R2b decreases.

In the first boundary region R1b, each separation distance di of the first dummy group DG1 to a nth dummy group DGn increases as the distance from the second boundary region R2b decreases, and the separation distance di may be simultaneously satisfied in the dummy channel structure DCHi on both ends, and thus, a shape in which the dummy channel structure DCH is disposed may form a trapezoidal shape, as illustrated in FIG. 4. That is, a separation distance di from the dummy channel structure DCHi on one end in one column may be identical to a separation distance di from the dummy channel structure DCHi on the other end.

The separation distance di of each dummy group DGi may gradually increase from the cell region Ra1 to the second boundary region R2b. The gradual increasing may be considered to have a constant slope θ1 with respect to a center line l1 (see figure 3A) of the first separation regions MS1 or the second central separation regions MS2a of a trapezoidal inclined side.

Furthermore, a relationship of separation distances d1 to dn between a plurality of dummy groups DG1 to DGn may be defined according to a distance between the plurality of dummy groups DG1 to DGn in the X-direction.

That is, a ratio of a difference di-d1 between separation distances between the first dummy group DG1 and the ith dummy group DGi to a distance between the first dummy group DG1 and the ith dummy group DGi in the X-direction may be equal to a ratio of a difference dn-di between separation distances between the nth dummy group DGn and the ith dummy group DGi to a distance between the nth dummy group DGn and the ith dummy group DGi in the X-direction.

In this manner, when the length da and db of each dummy group DGi decreases with the same ratio, intervals between the dummy channel structures DCH in each column in the Y-direction are identical to each other, and the number of dummy channel structures DCHs forming each dummy group DGi may decrease.

That is, when there are nine dummy channel structures DCH of the first dummy group DG1, a next dummy group DG2 may be disposed while the number of dummy channel structures DCH is decreased one by one.

A dummy channel structure DCHi on one end of a last dummy group DGn may be disposed to have a largest separation distance from the separation regions MS1 and MS2a, and may be disposed to have a distance greater than a reference distance from a separation insulating layer 105 corresponding to a boundary between the dummy channel structures DCH and the first support structure SH1.

The dummy channel structures DCH may be symmetrically disposed in the second boundary region R2b with the separation regions MS1 and MS2a in the X-direction as an axis.

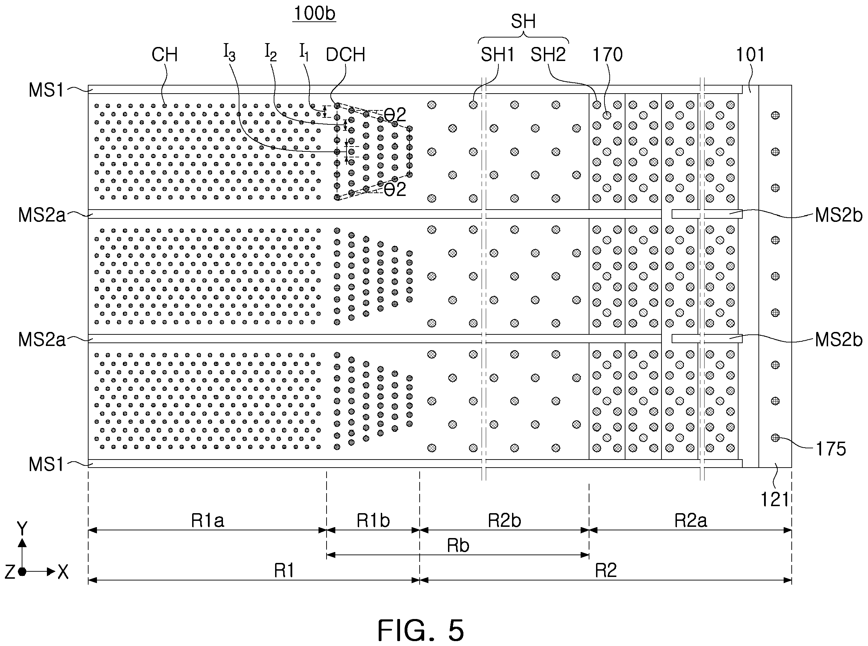

Referring to FIG. 5, in a semiconductor device 100b, in the first boundary region R1b, a separation distance di from the center line l1 extending in the X-direction along a center of widths of the first separation regions MS1 or the second central separation regions MS2a in the Y-direction to the dummy channel structure DCHi on one end of each dummy group DGi may increase as a distance from the second boundary region R2b decreases.

A shape in which the dummy channel structures DCH are disposed may have a trapezoidal shape as illustrated in FIG. 1. A separation distance di of one end of the dummy group DGi may be identical to a separation distance di of the other end.

When the separation distance di of each dummy group DGi increases at the same ratio,, an interval Ii (i=1, 2, ..., n) between the dummy channel structures DCH and the number of dummy channel structures DCH of each dummy group DGi in the Y-direction may be changed.

That is, when there are nine dummy channel structures DCH of the first dummy group DG1 and the interval I1 between the dummy channel structures DCH in the Y-direction has a first value, the number of dummy channel structures DCH of the second dummy group DG2 is nine as in the first dummy group DG1, but an interval I2 between the dummy channel structures DCH in the Y-direction may satisfy a second value less than the first value. Accordingly, a length of the second dummy group DG2 may be less than a length of the first dummy group DG1.

In the third dummy group DG3, the dummy channel structures DCH may be decreased to eight, and an interval I3 between the dummy channel structures DCH may satisfy the first value.

In this manner, an example in which the number of dummy channel structures DCH decreases while alternating columns decreases and an example in which an interval between the dummy channel structures DCH decreases may be repeated, thereby gradually decreasing a length of the dummy group DGi toward the second boundary region R2b.

In this example, a ratio θ2 of the separation distance di may have a value less than the ratio θ1 of the separation distance di of FIG. 4.

Accordingly, the separation distance di between the dummy channel structures DCHi on both ends and the separation regions MS1 and MS2a may satisfy the reference distance or more, and at the same time, a region without a vertical structure between the dummy channel structures DCHi on both ends and the adjacent separation regions MS1 and MS2a may be reduced or minimized.

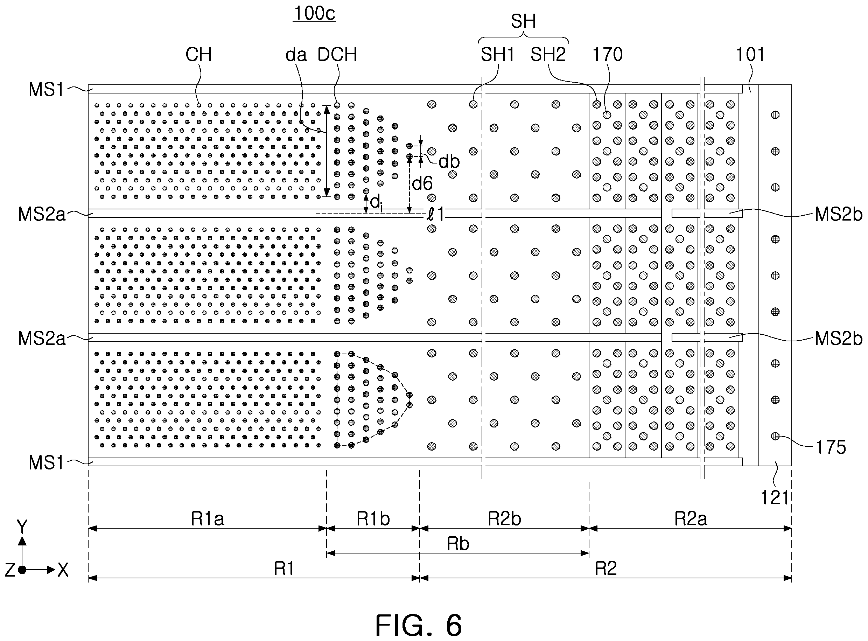

Referring to FIG. 6, in a semiconductor device 100c, the dummy channel structures DCH of the first boundary region R1b may form a plurality of columns and may be spaced apart from each other, and a separation distance di of each dummy group DGi from a center line 11 extending in the X-direction along a center of widths of the separation regions MS1 and MS2a in the Y-direction may rapidly increase as a distance from the second boundary region R2b decreases.

The separation distance di of each dummy group DGi may be increased at a different ratio, and a ratio of a separation distance di of the dummy group DGi close to the cell region R1a may be very small, and as the dummy group DGi approaches the second boundary region R2b, the ratio may rapidly increase. When intervals Ii between the dummy channel structures DCH of each dummy group DGi in in the Y-direction are identical to each other, the number of dummy channel structures DCH of each dummy group DGi may decrease rapidly as it approaches the second boundary region R2b. That is, when there are nine dummy channel structures DCHs of the first dummy group DG1 and the second dummy group DG2, the number of dummy channel structures DCHs reducing while decreasing the distance from the second boundary region R2b may rapidly increase to two or three.

In other embodiments, when the intervals Ii between the dummy channel structures DCH of each dummy group DGi in the Y-direction are different from each other, an interval Ii between the dummy channel structures DCH of each dummy group DGi may decrease rapidly as the distance from the second boundary regions R2b decreases. Furthermore, as the interval Ii between the dummy channel structures DCH of each dummy group DGi in the Y-direction and the number of dummy channel structures DCH are changed to reduce the distance from the second boundary region R2b, a ratio of the separation distance di may increase rapidly. Accordingly, an arrangement of dummy channel structures DCH in the first boundary region R1b may have a bell shape, but embodiments of the present disclosure is not limited thereto.

Since the separation distance di has a large value only in a portion close to the second boundary region R2b, a region without a vertical structure may be reduced or minimized while securing a reference distance from the separation regions MS1 and MS2a.

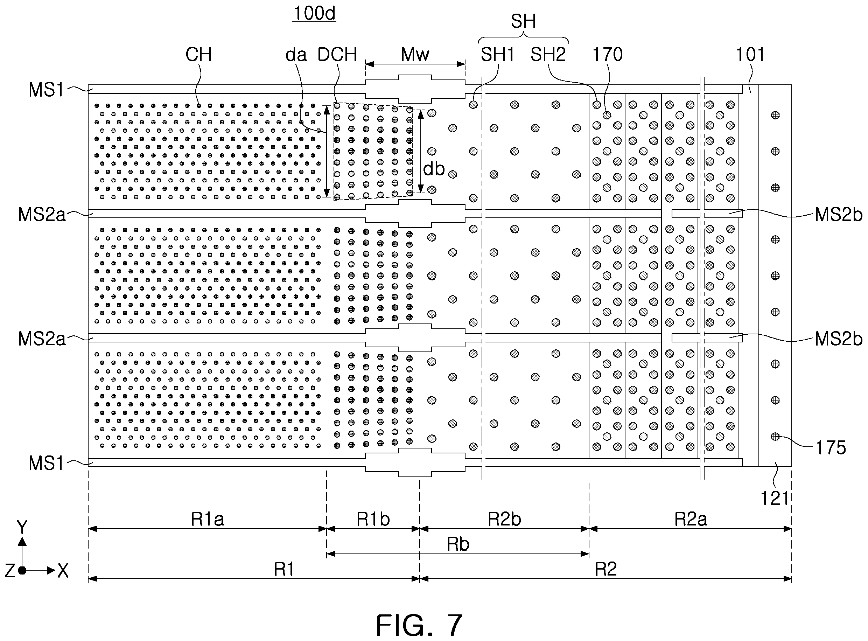

Referring to FIG. 7, in a semiconductor device 100d, each of separation regions MS 1 and MS2a including a first separation region MS 1 and a second intermediate separation region MS2a may include an extension portion Mw extending in the X-direction by having a first width in the Y-direction and having a second width greater than the first width.

The extension portion Mw may be disposed between a first boundary region R1b and a second boundary region R2b, specifically, in a boundary region Rb in which a dummy channel structure DCH and a first support structure SH1 are disposed.

The extension portion Mw may have a variable width, and as illustrated in FIG. 7, the extension portion Mw may have a shape in which a width thereof increases to lead to the largest width in a last column of the dummy channel structures DCH, i.e., in an area facing a dummy group DGn having the shortest length, and the width thereof gradually decreases toward the second boundary region R2b.

For example, the extension portion Mw may have a stepped structure that gradually increases in width, and the expansion portion Mw may decrease in a stepwise manner again while passing through a maximum width portion toward the second boundary region R2b. In other embodiments, the expansion portion Mw may have a curved surface and may have an oval shape with an increased width, but embodiments of the present disclosure are not limited thereto.

In this example, any one of FIGS. 1, 4, 5, or 6 may be applied to an arrangement of the dummy channel structures DCH. In this manner, a separation distance di of a last dummy group DGn close to the first support structure SH1 may satisfy a reference distance or more from a center line 11 of a width of the first separation region MS1 or the second intermediate separation region MS2a, and at the same time, a distance between an outside of a separation insulating layer 105 of the expansion portion Mw and the dummy channel structure DCH by being arranged to correspond to the expansion portion Mw having an increased width may satisfy a predetermined distance or less. Accordingly, a region without a vertical structure may be reduced or minimized to prevent or reduce the risk of collapse, and at the same time, when an opening for the first separation region MS 1 or the second intermediate separation region MS2a is formed, an aspect ratio may be reduced to alleviate plasma over-etching.

A separation distance dn from the dummy channel structure DCHn on one end of the nth dummy group DGn adjacent to the extension portion Mw of one of the first separation region MS 1 or the second intermediate separation region MS2a to the first separation region MS 1 or the second intermediate separation region MS2a may be less than a minimum distance between the first separation region MS 1 or the second intermediate separation region MS2a in the cell region R1a and channel structures CH on one end adjacent thereto.

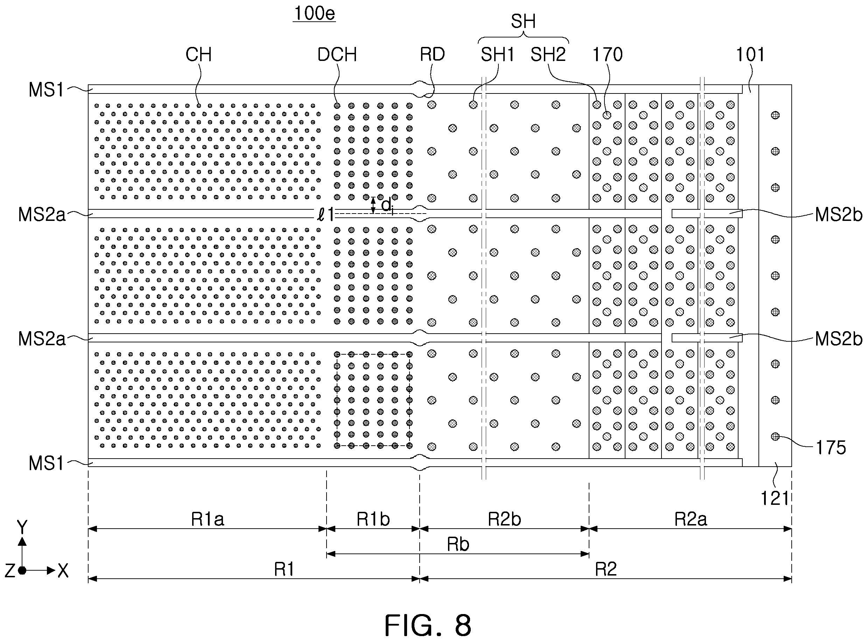

Referring to FIG. 8, in a semiconductor device 100e, among first and second separation regions MS1, MS2a and MS2b, a separation insulating layer 105 forming the first separation regions MS 1 and the second central separation regions MS2a extending from a first region R1 to a second region R2 may have a protrusion RD protruding from a side surface to dummy channel structures DCH between the first region R1 and the second region R2, specifically between a first boundary region R1b and a second boundary region R2b.

The protrusion RD may be a structure formed by bending the separation insulating layer 105 toward the dummy channel structures DCH, but the separation insulating layer 105 may be a structure that extends in the X-direction and partially protrudes from a side surface thereof.

The protrusion RD may be disposed below in the Z-direction a side surface of the separation insulating layer 105 on the second substrate 101, that is, below an upper interlayer insulating layer 125, but is not limited thereto.

A size of the protrusion RD, specifically, the farthest distance from an external side surface of the separation insulating layer 105 to an external surface of the protrusion RD, may be approximately 195 nm or less, in some embodiments 192 nm or less, and in further embodiments 170 nm or less. The protrusion RD may have a length corresponding to at least one gate electrode 130 below the upper interlayer insulating layer 125, but embodiments of the present disclosure are not limited thereto. A farthest point of an external surface of the protrusion RD may be biased toward the dummy channel structure DCH, but embodiments of the present disclosure are not limited thereto.

Both channel structures CH disposed in the Y-direction with respect to any one of the first and second separation regions MS1, MS2a and MS2b may be symmetrical with the first and second separation regions MS 1 and MS2a in the x-direction as an axis. Furthermore, for one of the first and second separation regions MS1 and MS2a, dummy channel structures DCH on both sides disposed in the Y-direction may be symmetrical with the first and second separation regions MS1 and MS2a in the X-direction as an axis. Furthermore, for one of the first and second separation regions MS1 and MS2a, the first support structures SH1 on both sides disposed in the Y-direction may be symmetrical with the first and second separation regions MS 1 and MS2a in the X-direction as an axis.

The dummy channel structures DCH of the first boundary region R1b may form a plurality of columns in the Y-direction and may be spaced apart from each other, and separation distances di of the plurality of dummy groups DGi from a center line 11 extending in the X-direction along a center of a width of the separation regions MS1 and MS2a in the Y-direction may all be identical to each other. In embodiments, the dummy channel structures of figure 8 are arrange din accordance with any one of figures 1 and 4 to 7.

Intervals of the dummy channel structures DCH of each dummy group DGi may be the same, the number of dummy channel structures DCH may be same, and dummy channel structures DCH may be disposed in a matrix, and a distance from a dummy channel structure DCH on one end of the last dummy group DGn to the protrusion RD may satisfy a reference value or more.

The reference value may be at least 180 nm or more, in some embodiments 190 nm or more, and in further embodiments 192 nm or more, but embodiments of the present disclosure are not limited thereto.

Some protrusions RD may be formed by securing a symmetrical arrangement of the channel structure CH and the dummy channel structure DCH and a separation distance di between the dummy channel structure DCH and the first and second separation regions MS1, MS2a and MS2b equal to or greater than the reference value, but the protrusion RD may be reduce or minimized to not cause device defects, such as an occurrence of a leakage current.

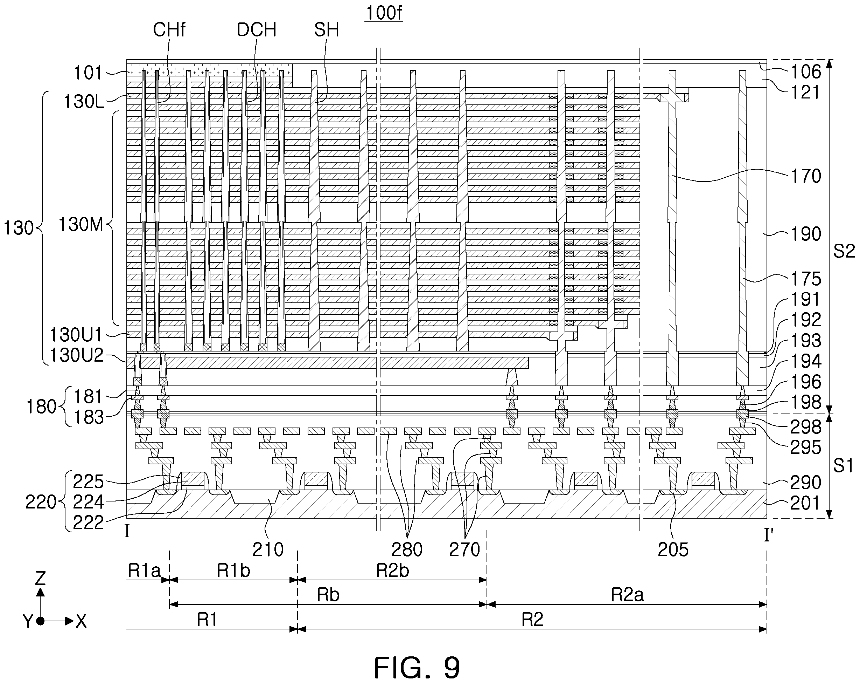

FIG. 9 is a schematic cross-sectional view of a semiconductor device 100f according to example embodiments. FIG. 9 illustrates a cross-section corresponding to FIG. 2A.

Referring to FIG. 9, a semiconductor device 100g may include a first semiconductor structure S1 and a second semiconductor structure S2 bonded through a wafer bonding manner.

The description of the peripheral circuit region PERI described above with reference to FIGS. 1 to 3B may be applied to the first semiconductor structure S1. However, the first semiconductor structure S1 may further include first bonding vias 295, first bonding metal layers 298, and first bonding insulating layer 299, which are bonding structures. The first bonding vias 295 may be disposed above a circuit wiring lines 280 in the Z-direction on an uppermost portion and may be connected to the circuit wiring lines 280. At least a portion of the first bonding metal layers 298 may be connected to the first bonding vias 295 on the first bonding vias 295. The first bonding metal layers 298 may be connected to a second bonding metal layers 198 of the second semiconductor structure S2. The bonding metal layers 298 may provide an electrical connection path according to a bonding between the first semiconductor structure S1 and the second semiconductor structure S2 together with the second bonding metal layers 198. Some of the first bonding metal layers 298 may not be connected to the lower circuit wiring lines 280 and may be disposed only for bonding. The first bonding vias 295 and the first bonding metal layers 298 may include a conductive material, for example, copper (Cu). The first bonding insulating layer 299 may be disposed around the first bonding metal layers 298. The first bonding insulating layer 299 may function as a diffusion barrier of the first bonding metal layers 298, and may include one or more insulating materials, for example, SiN, SiON, SiCN, SiOC, SiOCN, and/or SiO.

Unless otherwise specified, the description of the memory cell region CELL described above with reference to FIGS. 1 to 3B may be applied to the second semiconductor structure S2. The second semiconductor structure S2 may include wiring lines 183, which are cell wiring structures, and may further include second bonding vias 196, second bonding metal layers 198, and second bonding insulating layers 199, which are bonding structures. The second semiconductor structure S2 may further include a passivation layer 106 on and at least partially covering upper surfaces of a second substrate 101 and a substrate insulating layer 121.

The cell wiring lines 183 may be connected to upper contact plugs 181. However, in example embodiments, the number and arrangement of layers of plugs and wiring lines forming the cell wiring structure may be variously changed. The cell wiring lines 183 may be formed of a conductive material and may include, for example, one or more of tungsten (W), aluminum (Al), and/or copper (Cu).

The second bonding vias 196 and the second bonding metal layers 198 may be disposed below the cell wiring lines 183 in the Z-direction. The second bonding vias 196 may connect the cell wiring lines 183 to the second bonding metal layers 198, and the second bonding metal layers 198 may be bonded to the first bonding metal layers 298 of the first semiconductor structure S1. The second bonding insulating layer 199 may be bonded and connected to the first bonding insulating layer 299 of the first semiconductor structure S1. The second bonding vias 195 and the second bonding metal layers 198 may include a conductive material, for example, copper (Cu). The second bonding insulating layer 199 may include one or more of, for example, SiO, SiN, SiCN, SiOC, SiON, and/or SiOCN.

The first and second semiconductor structures S1 and S2 may be bonded by bonding the first bonding metal layers 298 to the second bonding metal layers 198 and bonding the first bonding insulating layer 299 to the second bonding insulating layer 199. The bonding of the first bonding metal layers 298 and the second bonding metal layers 198 may be, for example, a copper (Cu)-copper (Cu) bonding, and the bonding of the first bonding insulating layer 299 and the second bonding insulating layer 199 may be, for example, a dielectric-dielectric bonding such as SiCN-SiCN bonding. The first and second semiconductor structures S1 and S2 may be bonded by hybrid bonding including copper (Cu)-copper (Cu) bonding and dielectric-dielectric bonding.

The passivation layer 106 may be disposed on an upper surface of the second substrate 101 and may protect the semiconductor device 100f. The passivation layer 106 may include one or more insulating materials, for example, silicon oxide, silicon nitride, and/or silicon carbide. The substrate insulation layer 121 may be widely disposed in a connection region R2a to be on and at least partially cover upper ends of the contact plugs 170. However, in example embodiments, the substrate insulating layer 121 may have various arrangements in a range of electrically separating the contact plugs 170 from the second substrate 101.

In this example embodiment, the second semiconductor structure S2 need not include the first and second horizontal conductive layers 102 and 104 (see FIG. 2A). First channel structures CHf may be directly connected to the second substrate 101 in a state in which channel layers 140 are exposed through an upper end thereof. However, an electrical connection form of the first channel structures CHf and the common source line may be variously changed in example embodiments, and the first channel structures and the source structure may have the same structure as the example embodiment of FIG. 2A.

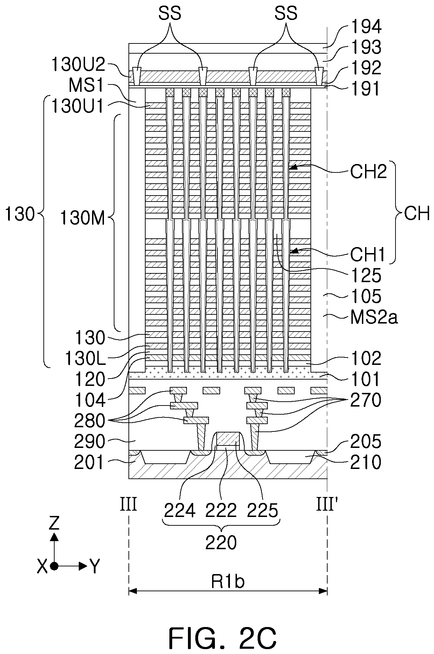

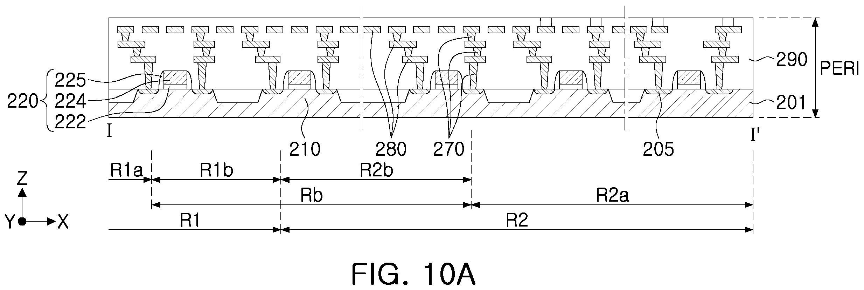

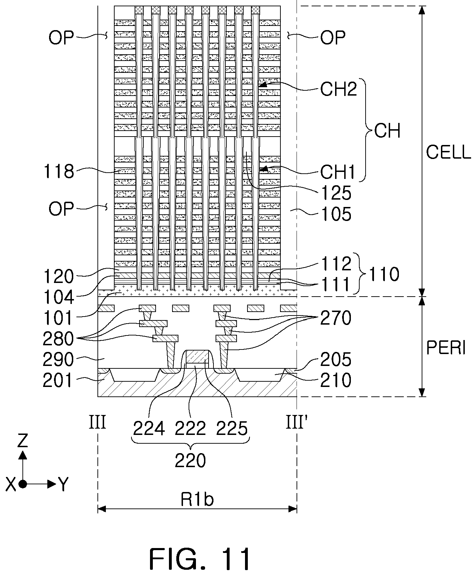

FIG. 2A, FIGS. 10A to 10K, and FIG. 11 are schematic cross-sectional views illustrating a method of manufacturing a semiconductor device according to example embodiments. FIGS. 10A to 10K are cross-sections corresponding to FIG. 2A, and FIG. 11 is a cross-section corresponding to FIG. 2C.

Referring to FIGS. 2A and 10A, the peripheral circuit region PERI including circuit elements 220 and circuit wiring structures may be formed on the first substrate 201 provided with a memory cell region R1a, and a second substrate 101, a horizontal insulating layer 110, a second horizontal conductive layer 104, and a substrate insulating layer 121 may be formed on the peripheral circuit region PERI.

First, device isolation layers 210 may be formed in the first substrate 201, and a circuit gate dielectric layer 222 and a circuit gate electrode 225 may be sequentially formed on the first substrate 201. The device isolation layers 210 may be formed by, for example, a shallow trench isolation (STI) process. The circuit gate dielectric layer 222 and the circuit gate electrode 225 may be formed using atomic layer deposition (ALD) or chemical vapor deposition (CVD). The circuit gate dielectric layer 222 may be formed of silicon oxide, and the circuit gate electrode 225 may be formed of at least one of polycrystalline silicon or metal silicide layers, but embodiments the present disclosure are not limited thereto. Next, a spacer layer 224 and source/drain regions 205 may be formed on both sidewalls of the circuit gate dielectric layer 222 and the circuit gate electrode 225. According to example embodiment, the spacer layer 224 may be formed of a plurality of layers. Next, the source/drain regions 205 may be formed by performing an ion implantation process.

The circuit contact plugs 270 of the circuit wiring structures may be formed by forming a portion of the peripheral region insulating layer 290 and then partially etching and removing the formed peripheral region insulating layer 290, and burying a conductive material in the removed part. The circuit wiring lines 280 may be formed, for example, by depositing a conductive material and then patterning the same.

The peripheral region insulating layer 290 may be formed of a plurality of insulating layers. The peripheral region insulating layer 290 may be partially formed in each operation of forming the circuit wiring structures and may be partially formed in an upper portion of an uppermost circuit wiring line 280, and may be finally formed to be on and at least partially cover the circuit elements 220 and the circuit wiring structures.

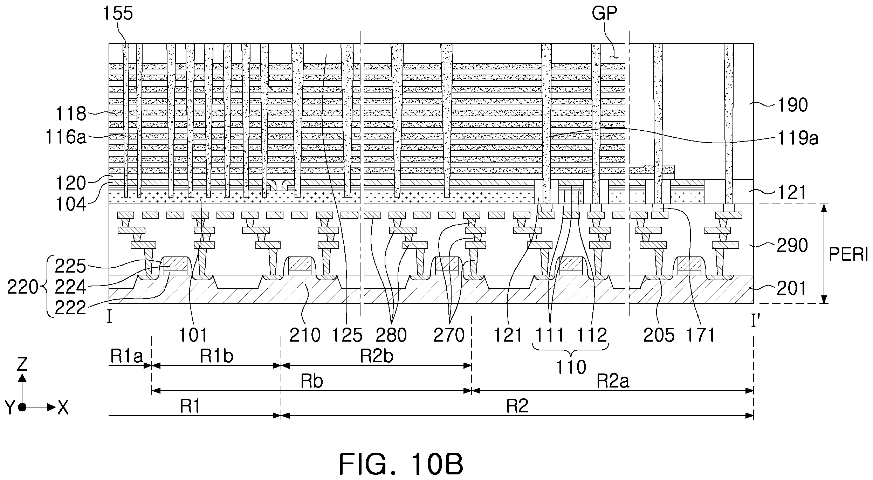

Next, referring to FIG. 10B, on the peripheral circuit region PERI, a second substrate 101 provided with a memory cell region CELL, a horizontal insulating layer 110, a second horizontal conductive layer 104, and a substrate insulating layer 121 may be formed, and sacrificial insulation layers 118 and interlayer insulation layers 120 may be alternately stacked to form a lower stack structure and to form first vertical sacrificial layers 116a and first contact sacrificial layers 119a.

The second substrate 101 may be formed on the peripheral region insulating layer 290. The second substrate 101 may be formed of, for example, polycrystalline silicon, and may be formed by a CVD process. The polycrystalline silicon forming the second substrate 101 may include impurities.

When the second substrate 101 is formed, landing pads 171 may be formed together on the uppermost circuit wiring lines 280. The landing pads 171 may be formed in regions in which lower ends of the contact plugs 170 (see FIG. 2A) are disposed. First, before forming the plate layer 101, openings may be formed by partially removing the peripheral region insulating layer 290 from the uppermost circuit wiring lines 280. When the second substrate 101 is formed, the landing pads 171 may be formed by at least partially filling the openings with a material forming the second substrate 101. The openings may be formed, for example, together with a ground via for connecting the second substrate 101 and the circuit wiring structure.

The first and second horizontal insulating layers 111 and 112 forming the horizontal insulating layer 110 may be alternately stacked on the second substrate 101. The horizontal insulating layer 110 may be layers partially replaced with the first horizontal conductive layer 102 of FIG. 2A through a subsequent process. The first horizontal insulating layers 111 may include a material different from that of the second horizontal insulating layer 112. For example, the first horizontal insulation layers 111 may be formed of the same material as the interlayer insulation layers 120, and the second horizontal insulation layer 112 may be formed of the same material as the subsequent sacrificial insulation layers 118. The horizontal insulating layer 110 may be partially removed from some regions, for example, the second region R2, by a patterning process.

The second horizontal conductive layer 104 may be formed on the horizontal insulation layer 110 and may be in contact with the second substrate 101 in a region in which the horizontal insulation layer 110 is removed. Accordingly, the second horizontal conductive layer 104 may be bent along ends of the horizontal insulating layer 110, and may be on and at least partially cover the ends thereof and extend onto the second substrate 101.

The substrate insulation layer 121 may be formed to penetrate or extend through the second substrate 101 in some regions including a region in which the contact plugs 170 (see FIG. 2A) are to be disposed. The substrate insulation layer 121 may be formed by partially removing the second substrate 101, the horizontal insulation layer 110 and the second horizontal conductive layer 104, and then burying an insulation material in the removed part. A planarization process may be further performed using a chemical mechanical polishing (CMP) process after the insulating material is embedded. Accordingly, an upper surface of the substrate insulating layer 121 may be substantially coplanar with an uppermost surface of the second horizontal conductive layer 104.

Next, the lower stack structure may be formed on the second horizontal conductive layer 104 and the substrate insulating layer 121 at a height in which the first channel structures CH1 (see FIG. 2A) are disposed.

The sacrificial insulating layers 118 may be layers in which at least a portion thereof is replaced with a portion of the gate electrodes 130 (see FIG. 2A) through a subsequent process. The sacrificial insulating layers 118 may be formed of a material different from that of the interlayer insulating layers 120. For example, the interlayer insulating layer 120 and the upper interlayer insulating layer 125 may be formed of silicon oxide and/or silicon nitride, and the sacrificial insulation layers 118 may be formed of a material different from the interlayer insulation layer 120, such as, for example, silicon, silicon oxide, silicon carbide, and/or silicon nitride.

According to example embodiments, the thicknesses of the interlayer insulating layers 120 may not all be the same. Furthermore, the thickness of the interlayer insulating layers 120 and the sacrificial insulating layers 118 and the number of formed films may be changed in various ways from those illustrated in the drawings.

The interlayer insulating layers 120 and the sacrificial insulating layers 118 forming the lower stack structure are alternately stacked on the second horizontal conductive layer 104.

A gate pad region 130P may be formed by repeatedly performing photolithography and etching processes on the sacrificial insulation layers 118 and the interlayer insulation layers 120. The gate pad regions 130P may be formed in a connection region R2a of the second region R2, and may be formed to include a region in which upper sacrificial insulating layers 118 extend to be shorter than lower sacrificial insulating layers 118. In the gate pad region 130P, asymmetric step structures GP may be formed so that an upper surface and an end of the plurality of sacrificial insulating layers 118 are exposed upwardly. However, in example embodiments, a specific shape of the gate pad region 130P may be variously changed. Sacrificial insulating layers 118 may be further formed on the stepped structure GP of the gate pad regions 130P, thus allowing the sacrificial insulating layers 118 disposed in an uppermost portion of each region to have a relatively thick thickness.

Next, a lower cell region insulating layer 190 on and at least partially covering the lower stack structure may be formed, and first vertical sacrificial layers 116a penetrating or extending through the lower stack structure may be formed.

The first vertical sacrificial layers 116a may be formed in positions corresponding to the first channel structures CH1, a lower portion of the dummy channel structures DCH, and a lower portion of the support structures SH in the first region R1 and the second boundary region R2b. The first contact sacrificial layers 119a may be formed in positions corresponding to the contact plugs 170 (see FIG. 2A) in the connection region R2a. The first vertical sacrificial layers 116a and the first contact sacrificial layers 119a may be formed at the same time. The first vertical sacrificial layers 116a and the first contact sacrificial layers 119a may be formed by forming first holes to penetrate or extend through the lower stack structure, and then depositing a sacrificial layer material in the first holes and performing a planarization process. The first hole may include holes corresponding to the channel structures CH1, the dummy channel structures DCH, the support structures SH, and the contact plugs 170. The first vertical sacrificial layers 116a and the first contact sacrificial layers 119a may include, for example, TiN and/or polycrystalline silicon.

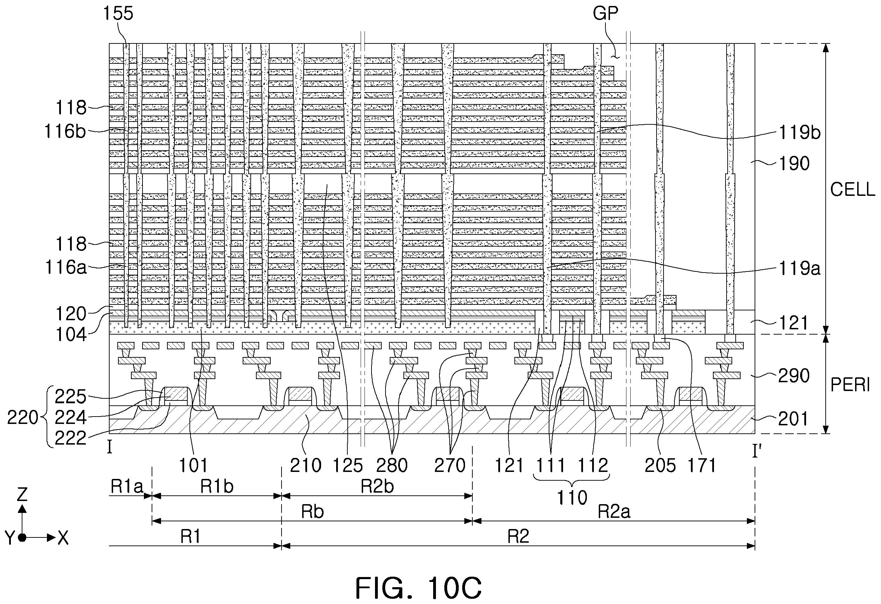

Referring to FIG. 10C, the sacrificial insulation layers 118 and the interlayer insulation layers 120 forming an upper stack structure may be alternately stacked on a lower stack structure, a stepped structure GP having a stepwise shape may be formed, an upper cell region insulating layer 190 may be formed, and second vertical sacrificial layers 116b and a second contact sacrificial layer 119b may be formed.

Each configuration of the upper stack structure may be formed in the same manner as a method of forming the lower stack structure.

The second vertical sacrificial layers 116b may be formed to be connected to the first vertical sacrificial layers 116a, respectively. The second contact sacrificial layers 119b may be formed to be connected to the first contact sacrificial layers 119a, respectively. The second vertical sacrificial layers 116b and the second contact sacrificial layers 119b may be formed by depositing the same material as the first vertical sacrificial layers 116a, for example, polycrystalline silicon.

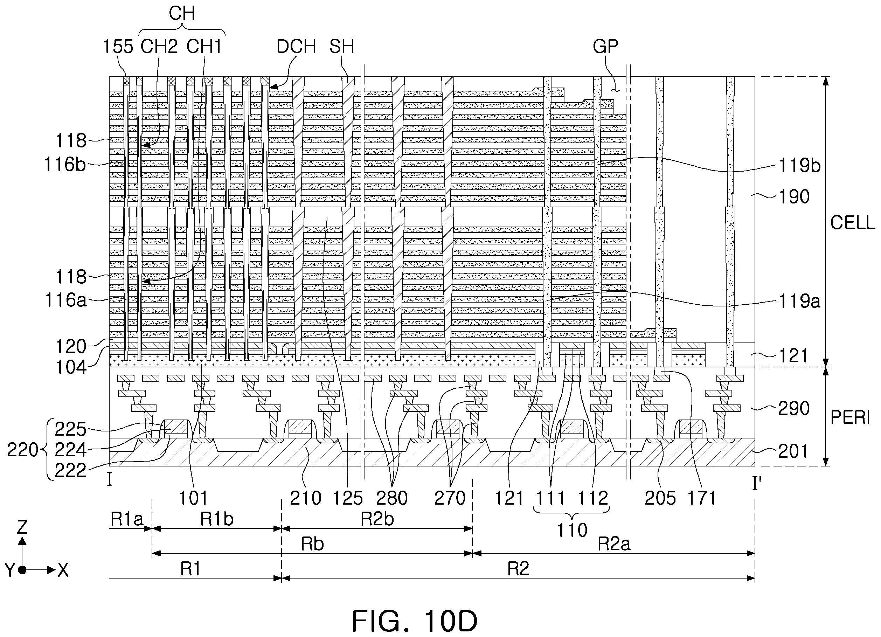

Referring to FIG. 10D, first and second channel structures CH1 and CH2 and dummy channel structures DCH penetrating or extending through the lower stack structure and the upper stack structure may be formed.

The first and second channel structures CH1 and CH2 may be formed by removing the first and second vertical sacrificial layers 116a and 116b and forming hole-shaped channel holes, and sequentially depositing at least a portion of a gate dielectric layer 145, a channel layer 140, a channel buried insulating layer 150, and a channel pad 155 in the channel holes.

The gate dielectric layer 145 may be formed to have a generally uniform thickness using an ALD or CVD process. In this operation, all or part of the gate dielectric layer 145 may be formed, and a portion extending vertically to the second substrate 101 along the first and second channel structures CH1 and CH2 may be formed in this operation. The channel layer 140 may be formed on the gate dielectric layer 145 in the channel holes. A channel buried insulating layer 150 may be formed to at least partially fill the channel holes and may be an insulating material. A channel pad 155 may be formed of a conductive material, for example, polycrystalline silicon. The dummy channel structures DCH may also be formed in the same shape as the first and second channel structures CH1 and CH2 by removing the first and second vertical sacrificial layers 116a and 116b.

After forming the channel structures CH and the dummy channel structures DCH, the support structures SH (see FIGS. 1 and 2A) of the second region R2 may also be formed in a similar manner. Specifically, the support structures SH may be formed by removing the first and second vertical sacrificial layers 116a and 116b and forming support holes, and then at least partially filling the support holes with a support insulating layer.

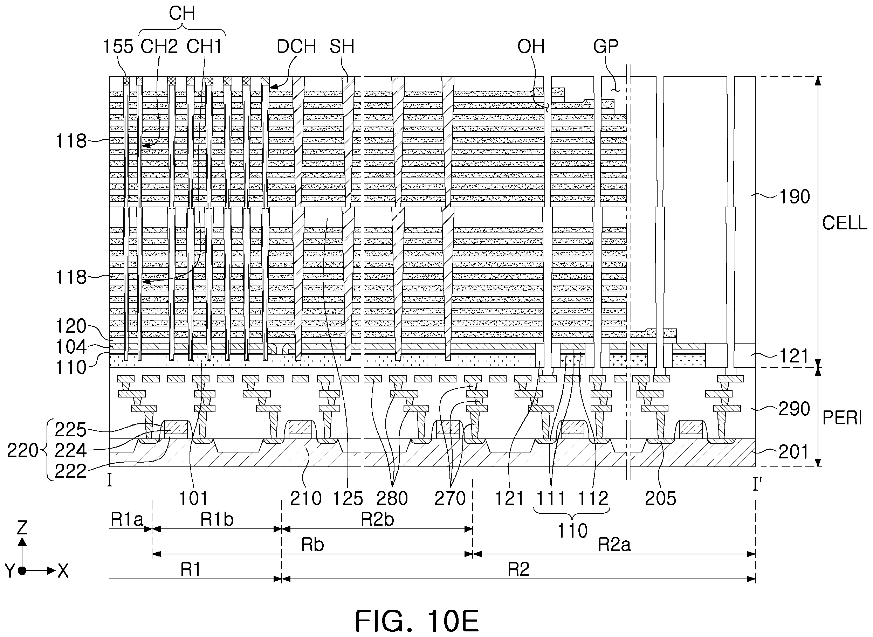

Referring to FIG. 10E, first contact holes OH may be formed by removing the first and second contact sacrificial layers 119a and 119b.

The first contact holes OH may be formed by selectively removing the first and second contact sacrificial layers 119a and 119b, and further removing exposed landing pads 171. Circuit wiring lines 280 may be exposed through bottom surfaces of the first contact holes OH. In some example embodiments, the landing pads 171 may not be removed in this operation but may be removed in a subsequent operation.

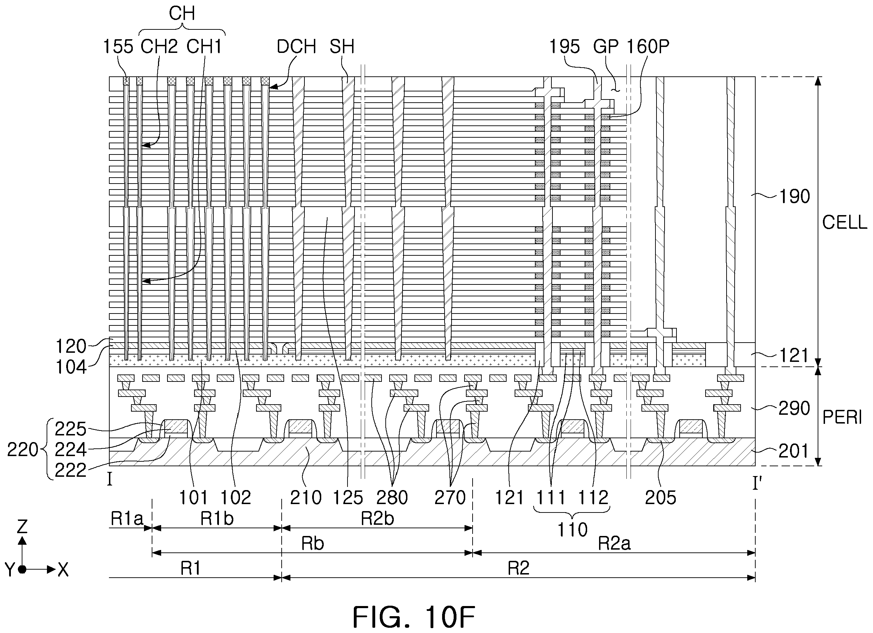

Referring to FIGS. 10F and 11, preliminary contact insulating layers 160P and vertical sacrificial layers 195 may be formed in the first contact holes OHs, and sacrificial insulating layers 118 may be removed.

First, the sacrificial insulating layers 118 exposed through the first contact holes OH may be partially removed. Contact tunnel portions may be formed by removing the sacrificial insulating layers 118 by a predetermined length from a circumference of the first contact holes OH. The contact tunnel portions are formed to have a relatively short length in the uppermost sacrificial insulating layers 118, and may be formed to have a relatively long length in sacrificial insulating layers 118 thereunder.

Specifically, first, conversely, the contact tunnel portions may be formed to be relatively long in the uppermost sacrificial insulating layers 118. This may be because the uppermost sacrificial insulating layers 118 include a region having a relatively faster etching rate than the sacrificial insulating layers 118 thereunder. Next, a separate sacrificial layer may be formed in the first contact holes OH and the contact tunnel portions. The sacrificial layer may be formed of a material having an etching rate lower than that of the sacrificial insulating layers 118. Next, portions of the sacrificial layer and the sacrificial insulating layers 118 may be removed, and in this case, the sacrificial layer may remain in the uppermost portion, and the sacrificial layer may be removed to partially remove the sacrificial insulating layers 118 in the lower portion. Accordingly, finally, the contact tunnel portions may be formed to have a relatively short length in the uppermost sacrificial insulating layers 118.

Preliminary contact insulating layers 1160P may be formed by depositing an insulating material in the first contact holes OHs and the contact tunnel portions. The preliminary contact insulating layers 160P may be formed on sidewalls of the first contact holes OHs and may at least partially fill the contact tunnel portions. In the uppermost sacrificial insulating layers 118, the preliminary contact insulating layers 160P may not completely fill the contact tunnel portions.

The vertical sacrificial layers 195 may at least partially fill the first contact holes OHs and at least partially fill the uppermost contact tunnel portions. The vertical sacrificial layers 195 may include a material different from that of the preliminary contact insulating layers 1160P, and may include, for example, polycrystalline silicon.

Next, as illustrated in FIG. 11, openings OP extending to the second substrate 101 by penetrating or extending through the sacrificial insulating layers 118 and the interlayer insulating layers 120 may be formed in positions of the first and second separation regions MS1, MS2a and MS2b (see FIG. 1). Next, an etch-back process may be performed while forming separate sacrificial spacer layers in the openings OP, and in the first region R1, the horizontal sacrificial layer 110 may be selectively removed, and a portion of an exposed first gate dielectric layer 145 may also be removed. After forming the first horizontal conductive layer 102 by depositing a conductive material in a region in which the horizontal sacrificial layer 110 has been removed, the sacrificial spacer layers may be removed within the openings. By this operation, the first horizontal conductive layer 102 may be formed in the first region R1.

During etching in a process of forming the openings OP, plasma-charged ions may be concentrated toward the dummy channel structure DCH according to a difference in Coulomb force between the dummy channel structure DCH and the support structure SH, which may result in defects such as over-etching toward the dummy channel structure DCH.

This etching asymmetry is caused by a difference in conductivity because the dummy channel structures DCH include a conductive channel layer and the first support structures SH1 do not include a conductive material. However, in this example embodiment, the channel structures CH and the dummy channel structures DCH may be symmetrically disposed with respect to a center line l1 of a width of the first separation regions MS1 and the second central separation regions MS2a, and as the dummy channel structures DCH are disposed by forming columns, they may be disposed so that a separation distance di between the dummy channel structure DCH on one end of each column and the separation regions MS1 and MS2a increases as a distance from the support structures SH1 decreases. Accordingly, the separation distance di between the dummy channel structure DCH on one end and the separation regions MS1 and MS2a increases as it approaches the second boundary region R2b within the first boundary region R1b, and an influence of the dummy channel structures DCH on the conductive channel layer may be weakened to disperse the electric field. Due to the electric field dispersion, a protrusion generated by bending a side surface of the openings OP in the Y-direction may be reduced or minimized, thereby preventing or reducing the risk of defects such as a leakage current.

Next, the sacrificial insulation layers 118 may be selectively removed from the interlayer insulation layers 120, the second horizontal conductive layer 104, and the preliminary contact insulation layers 160P, for example, using wet etching.

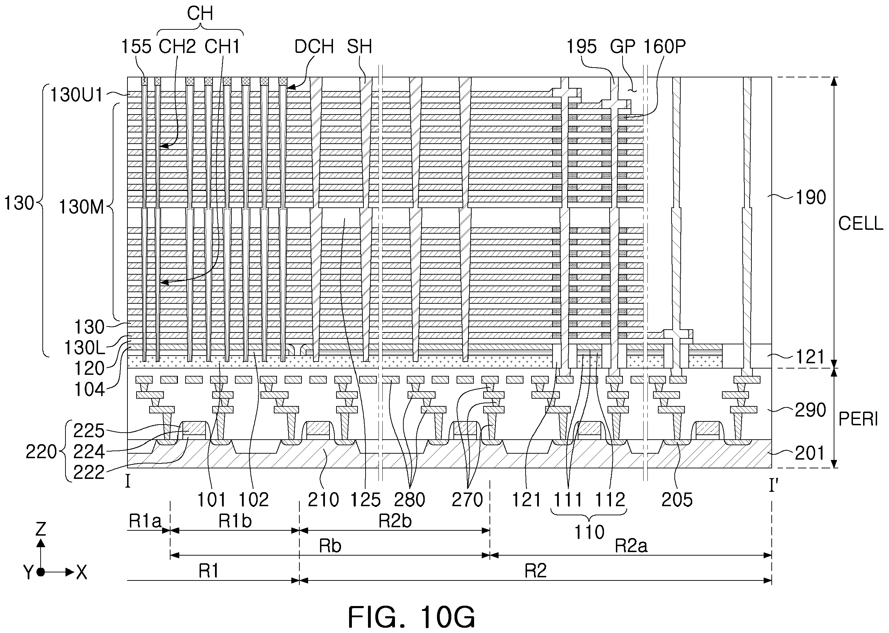

Referring to FIG. 10G, gate electrodes 130 may be formed.

The gate electrodes 130 may be formed by depositing a conductive material in regions in which the sacrificial insulating layers 118 have been removed. The conductive material may include metal, polycrystalline silicon, and/or a metal silicide material. In some example embodiments, a portion of the first gate dielectric layer 145 may be formed first before forming the gate electrodes 130.

After forming the gate electrodes 130, gate separation insulating layers 105 (see FIG. 2B) may be formed in the openings formed to correspond to the first isolation regions MS.

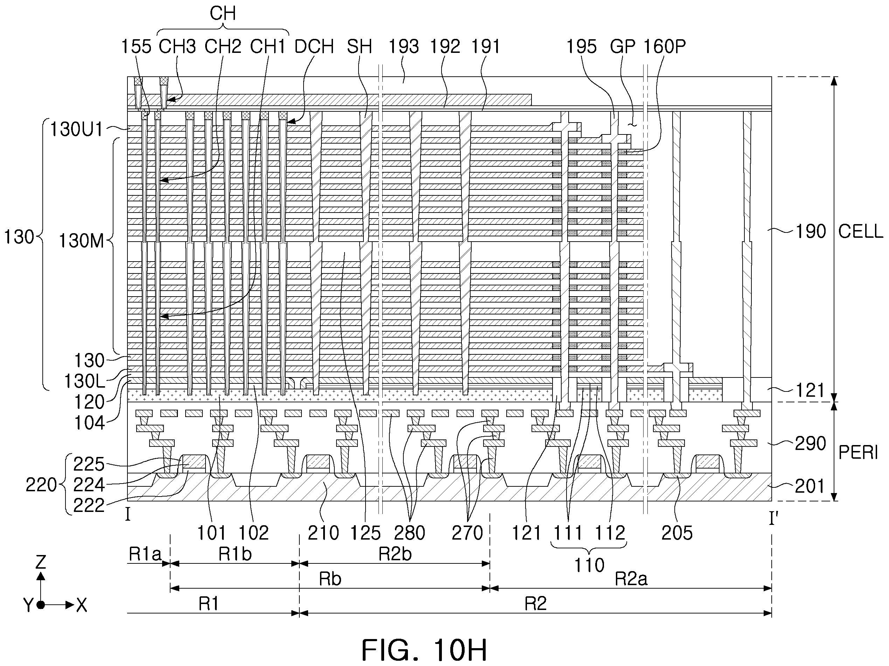

Referring to FIG. 10H, connection patterns CP of an upper horizontal insulating layer 191 may be formed, a second upper gate electrode 130U2 may be formed, and third channel structure CH3 penetrating or extending through the second upper gate electrode 130U2 may be formed.

The upper horizontal insulating layer 191 may be formed on second channel structures CH2, dummy channel structures DCH, and support structures SH. The connection patterns CP may be patterned on the second channel structures CH2 to be connected to the channel pads 155 of the second channel structures CH2 or may be formed by partial conversion of the upper horizontal insulating layer 191. Next, a first insulating layer 192 may be formed, and the second upper gate electrode 130U2 may be patterned and formed. The second upper gate electrode 130U2 may include a material different from that of the other gate electrodes 130, but the present disclosure is not limited thereto. For example, the second upper gate electrode 130U2 may include polycrystalline silicon. Next, a second insulating layer 193 may be further formed.

To form the third channel structures CH3, upper channel holes penetrating or extending through the second upper gate electrode 130U2 may first be formed, and then upper gate dielectric layers 145U, an upper channel layer 140U, an upper channel buried layer 150U, and an upper channel pad 155U may be formed sequentially, thus forming channel structures CH3. Each layer may be formed in the same manner as the first and second channel structures CH1 and CH2. The upper channel layers 140U may be formed to be connected to the connection patterns CP in a lower end thereof.

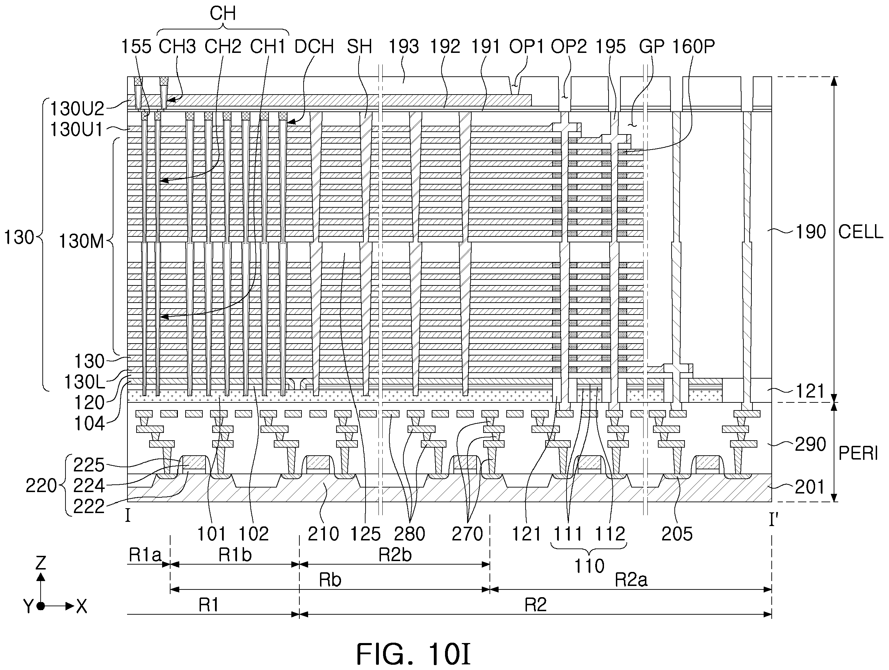

Referring to FIG. 10I, first and second openings OP1 and OP2 may be formed.

The first and second openings OP1 and OP2 may be formed to penetrate or extend through at least a portion of the second insulating layer 193. The first opening OP1 may be formed to at least partially expose the second upper gate electrode 130U2, and the second openings OP2 may penetrate or extend through the second insulating layer 193 and the upper horizontal insulating layer 191, so that preliminary contact insulating layers 160P and vertical sacrificial layers 195 may be at least partially exposed. The first and second openings OP1 and OP2 may be formed simultaneously or may be formed through separate processes.

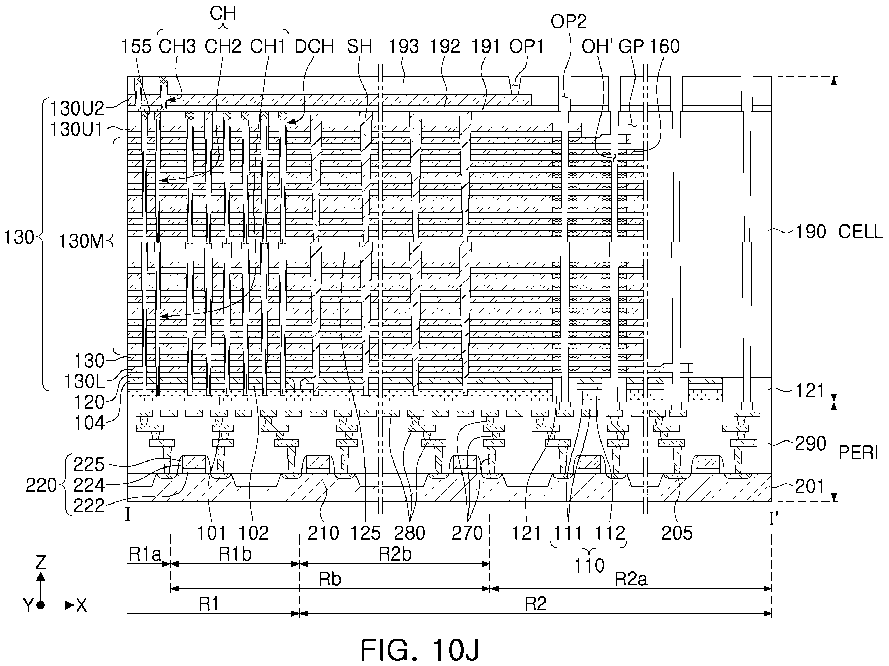

Referring to FIG. 10J, the vertical sacrificial layers 195 exposed through the second openings OP2 may be removed, and a portion of the preliminary contact insulating layers 160P may be removed to form second contact holes OH'.

The vertical sacrificial layers 195 may be selectively removed with respect to the interlayer insulating layers 120 and the gate electrodes 130. After the vertical sacrificial layers 195 are removed, a portion of the exposed preliminary contact insulating layers 160P may also be removed. In this case, all of the preliminary contact insulating layers 160P may be removed from the uppermost gate electrodes 130 corresponding to the contact regions 130P (see FIG. 2A), and remaining contact insulating layers 160 may be formed thereunder. In the contact regions 130P, when the first gate dielectric layer 145 is exposed after the preliminary contact insulating layers 160P are removed, the first gate dielectric layer 145 may also be removed, thus at least partially exposing side surfaces of the gate electrodes 130.

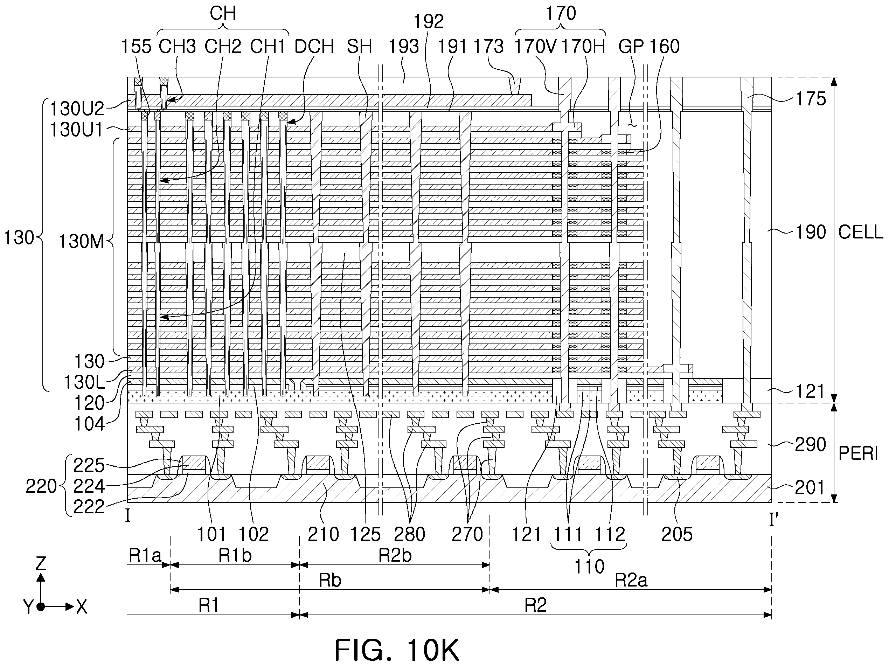

Referring to FIG. 10K, the contact plugs 170 and the upper contact plug 173 may be formed.

The contact plugs 170 and the upper contact plug 173 may be formed by depositing a conductive material in the second contact holes OH' and the first and second openings OP1 and OP2. The contact plugs 170 may be formed to have horizontal extensions 170H (see FIG. 2A) extending horizontally from the contact regions 130P, thereby being physically and electrically connected to the gate electrodes 130. The upper contact plug 173 may be deposited together with the contact plugs 170 or may be deposited in a separate process. A through-via 175 may also be formed through the same process.

Next, referring to FIG. 2A together, upper contact plugs 181 connected to upper ends of the contact plugs 170 and the third channel structures CH3 may be formed, and an upper circuit wiring 183 (including a bit line) may be formed on the third insulating layer 194 or the cell region insulating layer 190, thereby forming the semiconductor device 100.

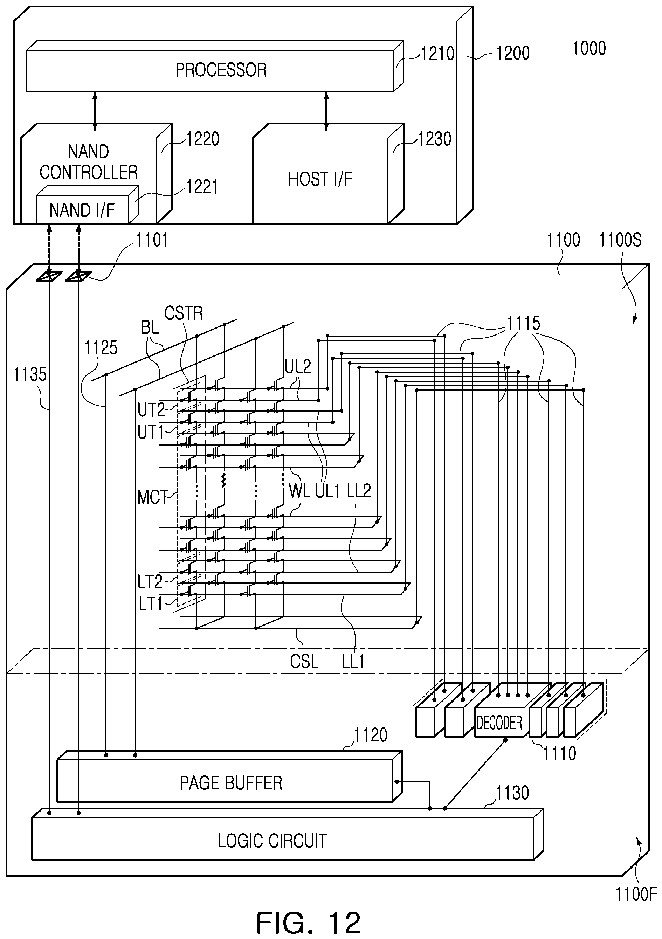

FIG. 12 is a schematic view of a data storage system including a semiconductor device according to example embodiments.

Referring to FIG. 12, a data storage system 1000 may include a semiconductor device 1100 and a controller 1200 electrically connected to the semiconductor device 1100. The data storage system 1000 may be a storage device including one or a plurality of semiconductor devices 1100 or an electronic device including a storage device. For example, the data storage system 1000 may be a solid state drive device (SSD) device, a universal serial bus (USB) device, a computing system, a medical device, or a communication device, including one or a plurality of semiconductor devices 1100.

The semiconductor device 1100 may be a non-volatile memory device, for example, a NAND flash memory device described above with reference to FIGS. 1 to 9. The semiconductor device 1100 may include a first structure 1100F and a second structure 1100S on the first structure 1100F. In example embodiments, the first structure 1100F may be disposed next to the second structure 1100S. The first structure 1100F may be a peripheral circuit structure including a decoder circuit 1110, a page buffer 1120, and a logic circuit 1130. The second structure 1100S may be a memory cell structure including a bit line BL, a common source line CSL, word lines WL, first and second gate upper lines UL1 and UL2, first and second gate lower lines LL1 and LL2, and memory cell strings CSTR between the bit line BL and the common source line CSL.

In the second structure 1100S, each memory cell string CSTR may include lower transistors LT1 and LT2 adjacent to the common source line CSL, upper transistors UT1 and UT2 adjacent to the bit lines BL, and a plurality of memory cell transistors MCT disposed between the lower transistors LT1 and LT2 and the upper transistors UT1 and UT2. The number of lower transistors LT1 and LT2 and the number of upper transistors UT1 and UT2 may vary, depending on example embodiments.

In example embodiments, the upper transistors UT1 and UT2 may include a string select transistor, and the upper transistors LT1 and LT2 may include a ground select transistor. The gate lower lines LL1 and LL2 may be gate electrodes of the lower transistors LT1 and LT2, respectively. The word lines WL may be gate electrodes of the memory cell transistors MCT, and the upper gate lines UL1 and UL2 may be gate electrodes of the upper transistors UT1 and UT2, respectively.

In example embodiments, the lower transistors LT1 and LT2 may include a lower erase control transistor LT1 and a ground selection transistor LT2 connected in series. The upper transistors UT1 and UT2 may include a string select transistor UT1 and an upper erase control transistor UT2 connected in series. At least one of the lower erase control transistor LT1 and the upper erase control transistor UT2 may be used in an erase operation of erasing data stored in memory cell transistors MCT using a GIDL phenomenon.

The common source line CSL, the first and second gate lower lines LL1 and LL2, the word lines WL, and the first and second gate upper lines UL1 and UL2 may be electrically connected to a decoder circuit 1110 through first connection wirings 1115 extending from the first structure 1100F to the second structure 1100S. The bit lines BL may be electrically connected to the page buffer 1120 through second connection wirings 1125 extending from the first structure 1100F to the second structure 1100S.

In the first structure 1100F, the decoder circuit 1110 and the page buffer 1120 may perform a control operation on at least one selected memory cell transistor among a plurality of memory cell transistors MCT. The decoder circuit 1110 and the page buffer 1120 may be controlled by the logic circuit 1130. The semiconductor device 1100 may communicate with the controller 1200 through an input/output pad 1101 electrically connected to the logic circuit 1130. The input/output pad 1101 may be electrically connected to the logic circuit 1130 through an input/output connection wiring 1135 extending from the first structure 1100F to the second structure 1100S.

The controller 1200 may include a processor 1210, a NAND controller 1220, and a host interface 1230. According to example embodiments, the data storage system 1000 may include a plurality of semiconductor devices 1100, and in this case, the controller 1200 may control the plurality of semiconductor devices 1100.

The processor 1210 may control an overall operation of the data storage system 1000, including the controller 1200. The processor 1210 may operate according to predetermined firmware and may control the NAND controller 1220 to access the semiconductor device 1100. The NAND controller 1220 may include a controller interface 1221 that processes communication with the semiconductor device 1100. Through the controller interface 1221, control commands for controlling the semiconductor device 1100, data to be recorded to the memory cell transistors MCT of the semiconductor device 1100, and data to be read from the memory cell transistors MCT of the semiconductor device 1100 may be transmitted. The host interface 1230 may provide a communication function between the data storage system 1000 and an external host. When receiving a control command from an external host through the host interface 1230, the processor 1210 may control the semiconductor device 1100 in response to the control command.

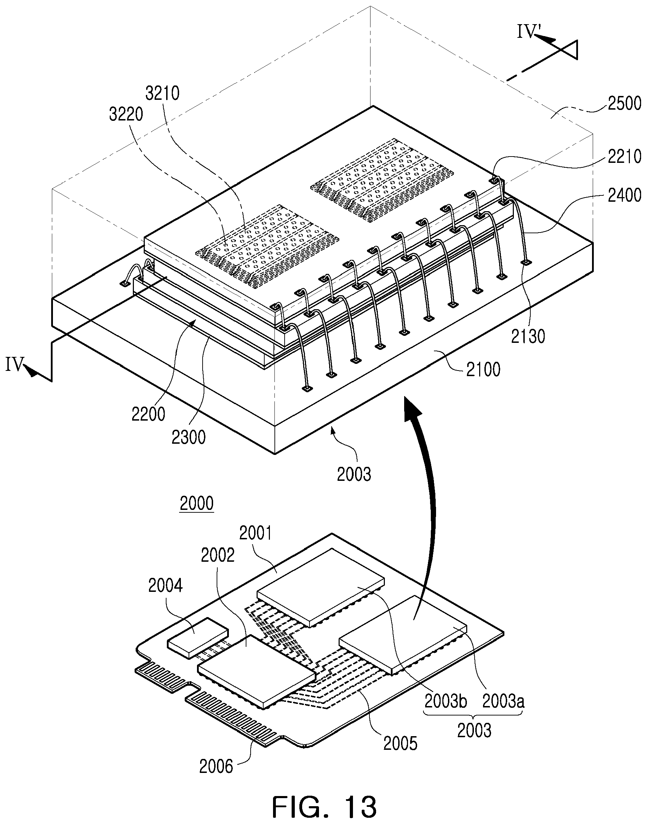

FIG. 13 is a schematic perspective view of a data storage system including a semiconductor device according to an example embodiment.

Referring to FIG. 13, a data storage system 2000 according to an example embodiment of the present disclosure may include a main board 2001, a controller 2002 mounted on the main board 2001, one or more semiconductor packages 2003, and a DRAM 2004. The semiconductor package 2003 and the DRAM 2004 may be connected to the controller 2002 through wiring patterns 2005 formed on the main board 2001.

The main board 2001 may include a connector 2006 including a plurality of pins coupled to an external host. The number and arrangement of the plurality of pins in the connector 2006 may vary, depending on a communication interface between the data storage system 2000 and the external host. In example embodiments, the data storage system 2000 may communicate with an external host according to any one of the interfaces of Universal Serial Bus (USB), Peripheral Component Interconnect Express (PCI-Express), Serial Advanced Technology Attachment (SATA), M-Phy for Universal Flash Storage (UFS). In example embodiments, the data storage system 2000 may operate with power supplied from the external host through the connector 2006. The data storage system 2000 may further include a power management integrated circuit (PMIC) configured to distribute power supplied from the external host to the controller 2002 and the semiconductor package 2003.

The controller 2002 may record data in the semiconductor package 2003 or read data from the semiconductor package 2003, and may improve the operating speed of the data storage system 2000.

The DRAM 2004 may be a buffer memory for alleviating a speed difference between the semiconductor package 2003, which is a data storage space, and the external host. The DRAM 2004 included in the data storage system 2000 may operate as a type of cache memory and may provide a space for temporarily storing data during control operations for the semiconductor package 2003. When the data storage system 2000 includes the DRAM 2004, the controller 2002 may further include a DRAM controller for controlling the DRAM 2004 in addition to the NAND controller for controlling the semiconductor package 2003.

The semiconductor package 2003 may include first and second semiconductor packages 2003a and 2003b spaced apart from each other. The first and second semiconductor packages 2003a and 2003b may each include a plurality of semiconductor chips 2200. Each of the first and second semiconductor packages 2003a and 2003b may include a package substrate 2100, semiconductor chips 2200 on the package substrate 2100, adhesive layers 2300 disposed on a lower surface of each of the semiconductor chips 2200, a connection structure 2400 electrically connecting the semiconductor chips 2200 to the package substrate 2100, and a molding layer 2500 on and at least partially covering the semiconductor chips 2200 and the connection structure 2400 on the package substrate 2100.

The package substrate 2100 may be a printed circuit board including upper package pads 2130. Each semiconductor chip 2200 may include an input/output pad 2210. The input/output pad 2210 may correspond to the input/output pad 1101 of FIG. 12. Each of the semiconductor chips 2200 may include gate stack structures 3210 and channel structures 3220. Each of the semiconductor chips 2200 may include the semiconductor device described above with reference to FIGS. 1 to 9.

In example embodiments, the connection structure 2400 may be a bonding wire electrically connecting the input/output pad 2210 and upper pads 2130 of the package. Accordingly, in each of the first and second semiconductor packages 2003a and 2003b, the semiconductor chips 2200 may be electrically connected to each other using a bonding wire manner, and may be electrically connected to the package upper pads 2130 of the package substrate 2100. According to example embodiments, in each of the first and second semiconductor packages 2003a and 2003b, the semiconductor chips 2200 may be electrically connected to each other by a connection structure including a through-silicon via (TSV), instead of a bonding wire-type connection structure 2400.

In example embodiments, the controller 2002 and the semiconductor chips 2200 may be included in one package. In an example embodiment, the controller 2002 and the semiconductor chips 2200 may be mounted on a separate interposer board different from the main board 2001, and the controller 2002 and the semiconductor chips 2200 may be connected to each other by a wiring formed on the interposer board.

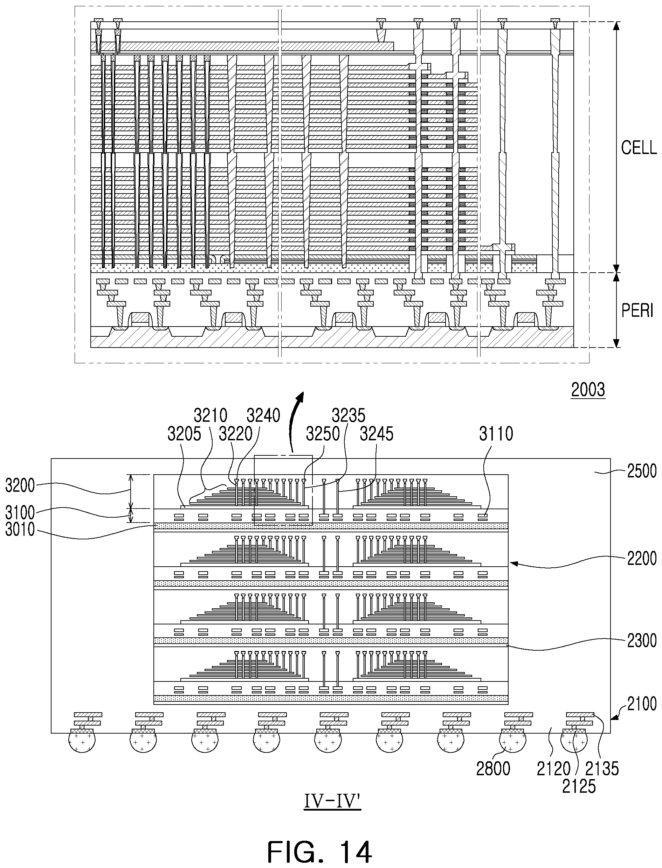

FIG. 14 is a cross-sectional view schematically illustrating a semiconductor package according to an example embodiment. FIG. 14 illustrates an example embodiment of the semiconductor package 2003 of FIG. 13, and conceptually illustrates a region in which the semiconductor package 2003 of FIG. 13 is cut along the cutting line IV-IV'.

Referring to FIG. 14, in the semiconductor package 2003, the package substrate 2100 may be a printed circuit board. The package substrate 2100 may include a package substrate body portion 2120, package upper pads 2130 (see FIG. 13) disposed on an upper surface of the package substrate body portion 2120, lower pads 2125 disposed on or exposed through a lower surface of the package substrate body portion 2120, and internal wirings 2135 electrically connecting upper pads 2130 and lower pads 2125 in the package substrate body portion 2120. The lower pads 2125 may be connected to wiring patterns 2005 of the main board 2001 of the data storage system 2000 as illustrated in FIG. 13 through conductive connections 2800.

Each of the semiconductor chips 2200 may include a semiconductor substrate 3010 and a first structure 3100 and a second structure 3200 sequentially stacked on the semiconductor substrate 3010. The first structure 3100 may include a peripheral circuit region including peripheral wirings 3110. The second structure 3200 may include a common source line 3205, a gate stack structure 3210 on the common source line 3205, channel structures 3220 penetrating or extending through the gate stack structure 3210, bit lines 3240 electrically connected to the channel structures 3220, and contact plugs 3235 electrically connected to the word lines WL (see FIG. 12) of the gate stack structure 3210. As described above with reference to FIGS. 1 to 9, a plurality of gate electrodes 130 in each of the semiconductor chips 2200 may be commonly connected to one contact plug 170.

Each of the semiconductor chips 2200 may include a through-wiring 3245 electrically connected to peripheral wirings 3110 of the first structure 3100 and extending into the second structure 3200. The through-wiring 3245 may be disposed outside the gate stack structure 3210 and may be further disposed to penetrate or extend through the gate stack structure 3210. Each of the semiconductor chips 2200 may further include an input/output pad 2210 (see FIG. 12) electrically connected to the peripheral wirings 3110 of the first structure 3100.

While the inventive concept has been particularly shown and described with reference to embodiments thereof, it will be understood that various changes in form and details may be made therein without departing from the scope of the following claims. Embodiments include the following numbered clauses:
Clause 1: A semiconductor device comprising:
   a stack structure in a first region and a second region and including gate electrodes and interlayer insulating layers alternately stacked;
   a plurality of separation regions extending through the stack structure in a third direction;
   a plurality of channel structures extending through the stack structure, in a cell region of the first region;
   a plurality of dummy vertical structures extending through the stack structure, in a buffer region of the first region;
   a plurality of first support structures extending through the stack structure, in a boundary region of the second region;
   contact plugs connected to contact regions of the gate electrodes, in a connection region of the second region; and
   a plurality of second support structures extending through the stack structure, in the connection region of the second region,
   wherein the cell region of the first region, the buffer region of the first region, the boundary region of the second region, and the connection region of the second region are sequentially disposed in a second direction,
   wherein the separation regions include a first separation region and a second separation region, adjacent to each other in the third direction, perpendicular to a first direction and the second direction, and
   wherein between a first central axis of the first separation region extending in the second direction and a second central axis of the second separation region extending in the second direction, distances between first dummy vertical structures adjacent to the first separation region among the dummy vertical structures and the first central axis increase from a region adj acent to the cell region of the first region to a region adj acent to the boundary region of the second region.
Clause 2: The semiconductor device of clause 1, wherein the channel structures include a channel layer,
   wherein the dummy vertical structures include a dummy channel layer,
   wherein the channel layer and the dummy channel layer include a first material, and
   wherein the first support structures and the second support structures include a support insulating layer, and do not include the first material.
Clause 3: The semiconductor device of claim 1 or 2, wherein a width of the channel structures is less than a width of the dummy vertical structures, and the width of the dummy vertical structures is less than a width of the first and second support structures.
Clause 4: The semiconductor device of claim 1, 2, or 3, wherein between the first central axis of the first separation region extending in the second direction and the second central axis of the second separation region extending in the second direction, an arrangement of the plurality of dummy vertical structures is different from an arrangement of the plurality of channel structures and an arrangement of the plurality of first support structures.
Clause 5. A data storage system comprising:
   a semiconductor storage device including a first semiconductor structure including circuit elements, a second semiconductor structure on one surface of the first semiconductor structure, and an input/output pad electrically connected to the circuit elements;
   a controller electrically connected to the semiconductor storage device through the input/output pad and configured to control the semiconductor storage device,
   wherein the second semiconductor structure comprises:
      a stack structure in a first region and a second region and including gate electrodes and interlayer insulating layers alternately stacked;
      a plurality of separation regions extending through the stack structure in a third direction;
      a plurality of channel structures extending through the stack structure, in a cell region of the first region;
      a plurality of dummy vertical structures extending through the stack structure, in a buffer region of the first region;
      a plurality of first support structures extending through the stack structure, in a boundary region of the second region;
      contact plugs connected to contact regions of the gate electrodes, in a connection region of the second region; and
      a plurality of second support structures extending through the stack structure, in the connection region of the second region,
      wherein the cell region of the first region, the buffer region of the first region, the boundary region of the second region, and the connection region of the second region are sequentially arranged in a second direction,
      wherein the separation regions include a first separation region and a second separation region, adjacent to each other in the third direction, perpendicular to a first direction and the second direction, and
      wherein between a first central axis of the first separation region extending in the second direction and a second central axis of the second separation region extending in the second direction, distances between the first dummy vertical structures adjacent to the first separation region among the dummy vertical structures and the first central axis increase from a region adj acent to the cell region of the first region to a region adj acent to the boundary region of the second region.

## Claims

1. A semiconductor device comprising:
a stack structure including gate electrodes that are spaced apart from each other in a first direction, perpendicular to an upper surface of a substrate, in a first region and a second region;
separation regions extending through the stack structure and extending in a second direction, perpendicular to the first direction, in the first region and the second region;
a plurality of channel structures extending through the stack structure, in a cell region of the first region;
a plurality of dummy channel structures extending through the stack structure, in a buffer region of the first region; and
a plurality of support structures extending through the stack structure, in the second region,
wherein the first region and the second region are sequentially arranged in the second direction,
wherein the separation regions include a first separation region and a second separation region, adjacent to each other in a third direction, and perpendicular to the first direction and the second direction,
wherein, between the first and second separation regions, the dummy channel structures include a first dummy group adjacent to the cell region and including first dummy channel structures sequentially arranged in the third direction, and a second dummy group adjacent to the second region and including second dummy channel structures sequentially arranged in the third direction, and
wherein a first length of the first dummy group in the third direction is longer than a second length of the second dummy group in the third direction.

2. The semiconductor device of claim 1, wherein a distance between the first separation region and the second dummy group is substantially identical to a distance between the second separation region and the second dummy group.

3. The semiconductor device of claim 1 or 2, wherein between the first and second separation regions, the dummy channel structures further include a third dummy group including third dummy channel structures sequentially arranged in the third direction between the first dummy group and the second dummy group, and
wherein a third length of the third dummy group in the third direction is shorter than the first length of the first dummy group in the third direction and is longer than the second length of the second dummy group in the third direction.

4. The semiconductor device of claim 3, wherein a number of the first dummy channel structures in the first dummy group, a number of the second dummy channel structures in the second dummy group, and a number of the third dummy channel structures in the third dummy group are different from each other.

5. The semiconductor device of claim 3 or 4, wherein a ratio of a distance (dn) between the first separation region and the second dummy group in the second direction and a distance between the first separation region and the third dummy group in the second direction is substantially identical to a ratio of a distance between the first separation region and the third dummy group in the second direction and a distance between the first separation region and the second dummy group in the second direction.

6. The semiconductor device of claim 3, 4, or 5, wherein a ratio of a distance between the first separation region and the second dummy group in the second direction and a distance between the first separation region and the third dummy group in the second direction is different from a ratio of a distance between the first separation region and the third dummy group in the second direction and a distance between the first separation region and the second dummy group in the second direction.

7. The semiconductor device of any one of claims 1 to 6, wherein a first interval between respective ones of the first dummy channel structures in the third direction is greater than a second interval between respective ones of the second dummy channel structures in the third direction.

8. The semiconductor device of any one of claims 1 to 7, wherein each of the channel structures has a first width,
at least one of the dummy channel structures has a second width greater than the first width, and
at least one of the support structures has a third width greater than the second width.

9. The semiconductor device of any one of claims 1 to 8, wherein the channel structures are disposed symmetrically about an axis with one of the separation regions extending in the second direction as the axis.

10. The semiconductor device of any one of claims 1 to 9, wherein between the first separation region and the second separation region, an arrangement of the channel structures is different from an arrangement of the dummy channel structures.

11. The semiconductor device of any one preceding claim, wherein the stack structure includes the gate electrodes and interlayer insulating layers alternately stacked;
the plurality of support structures include first support structures extending through the stack structure in a boundary region of the second region, and a plurality of second support structures extending through the stack structure, in the connection region of the second region;
the device further comprising contact plugs connected to contact regions of the gate electrodes, in a connection region of the second region; and
wherein the cell region of the first region, the buffer region of the first region, the boundary region of the second region, and the connection region of the second region are sequentially disposed in a second direction.

12. The semiconductor device of any one of claims 1 to 11, wherein distances between first dummy channel structures adjacent to the first separation region among the dummy channel structures and the first central axis increase from a region adjacent to the cell region of the first region to a region adjacent to the boundary region of the second region.

13. The semiconductor device of any one of claims 1 to 12, wherein the channel structures include a channel layer,
wherein the dummy vertical structures include a dummy channel layer,
wherein the channel layer and the dummy channel layer include a first material, and
wherein the first support structures and the second support structures include a support insulating layer, and do not include the first material.

14. The semiconductor device of any one of claims 11 to 13, wherein between the first central axis of the first separation region extending in the second direction and the second central axis of the second separation region extending in the second direction, an arrangement of the plurality of dummy channel structures is different from an arrangement of the plurality of channel structures and an arrangement of the plurality of first support structures.

15. A data storage system comprising:
a semiconductor storage device including a first semiconductor structure including circuit elements, a second semiconductor structure on one surface of the first semiconductor structure, and an input/output pad electrically connected to the circuit elements;
a controller electrically connected to the semiconductor storage device through the input/output pad and configured to control the semiconductor storage device,
wherein the second semiconductor structure is in accordance with the device as claimed in any on of claims 1 to 14.
